# EUROPÄISCHE PATENTSCHRIFT

(11) **EP 1 844 060 B1**
(45) Veröffentlichungstag und Bekanntmachung des Hinweises auf die Patenterteilung: **17.11.2010**
(21) Anmeldenummer: 06706411.3
(22) Anmeldetag: 26.01.2006
(51) Int. Cl.: C07F 15/00

(54) **METALLKOMPLEXE**
METAL COMPLEXES
COMPLEXES METALLIQUES

(30) Priorität: 03.02.2005 EP 05002237
(43) Veröffentlichungstag der Anmeldung: 17.10.2007
(73) Patentinhaber: Merck Patent GmbH, 64293 Darmstadt (DE)
(72) Erfinder: STOESSEL, Philipp, 60487 Frankfurt am Main (DE); BECKER, Heinrich, 65719 Hofheim (DE); VESTWEBER, Horst, 34630 Gilersberg-Winterscheid (DE); HEIL, Holger, 64295 Darmstadt (DE); FORTTE, Rocco, 65933 Frankfurt (DE)
(86) Internationale Anmeldenummer: PCT/EP2006/000651
(87) Internationale Veröffentlichungsnummer: WO 2006/081973

(56) Entgegenhaltungen:
- EP-A- 1 400 514
- PATENT ABSTRACTS OF JAPAN Bd. 2003, Nr. 12, 5. Dezember 2003 (2003-12-05) -& JP 2004 319438 A (KONICA MINOLTA HOLDINGS INC), 11. November 2004 (2004-11-11) in der Anmeldung erwähnt
- PATENT ABSTRACTS OF JAPAN Bd. 2003, Nr. 12, 5. Dezember 2003 (2003-12-05) -& JP 2004 311405 A (KONICA MINOLTA HOLDINGS INC), 4. November 2004 (2004-11-04) in der Anmeldung erwähnt

## Beschreibung

Die vorliegende Erfindung beschreibt neue Materialien, deren Verwendung in Elektrolumineszenzelementen und darauf basierende Displays.

Metallorganische Verbindungen, speziell Ir- und Pt-Verbindungen, werden in naher Zukunft in einer Reihe verschiedenartiger Anwendungen, die im weitesten Sinne der Elektronikindustrie zugerechnet werden können, Einsatz als funktionelle Materialien finden, z. B. in organischen Elektrolumineszenzvorrichtungen. Der allgemeine Aufbau solcher Vorrichtungen ist beispielsweise in US 4,539,507 und US 5,151,629 beschrieben. Hier ist die Markteinführung bereits erfolgt, wie die Autoradios der Firma Pioneer und die Mobiltelefone der Firmen Pioneer und SNMD mit "organischem Display" belegen. Weitere derartige Produkte stehen kurz vor der Einführung.

Eine Entwicklung, die sich in den letzten Jahren abzeichnet, ist der Einsatz metallorganischer Komplexe, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Ob sich diese Entwicklung durchsetzen wird, hängt davon ab, ob entsprechende Device-Kompositionen gefunden werden, die diese Vorteile (Triplett-Emission = Phosphoreszenz gegenüber Singulett-Emission = Fluoreszenz) auch in den OLEDs umsetzen können. Als wesentliche Bedingungen sind hier insbesondere eine hohe operative Lebensdauer und eine hohe thermische Stabilität der Komplexe zu nennen.

Allerdings gibt es bei OLEDs, die Triplettemission zeigen, immer noch erhebliche Probleme, die einer dringenden Verbesserung bedürfen. Dies gilt insbesondere auch für den Triplettemitter selbst. Die meisten in der Literatur bekannten Komplexe enthalten Liganden, die auf Phenylpyridin oder verwandten Strukturen basieren, die an Iridium oder Platin koordinieren (z. B. WO 02/068435, WO 04/026886). Dabei ist diese Struktur durch die Abwesenheit einer Brücke (Formel A) bzw. die Anwesenheit einer Alkylenbrücke mit 2 bis 20 C-Atomen, die gegebenenfalls durch Heteroatome ersetzt sein können, zwischen den beiden Cyclen (WO 03/000661, Formel B) charakterisiert.

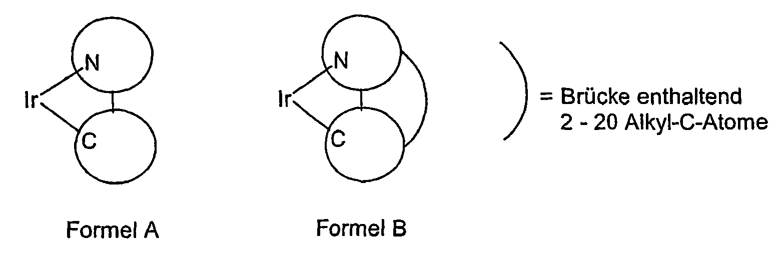

Verbindungen dieses Typs weisen in der Praxis einige entscheidende Schwachpunkte auf, welche einer Verbesserung bedürfen:
1. Ein entscheidender Mangel ist die unzureichende thermische Stabilität der oben beschriebenen Verbindungen. Zwar kann beispielsweise der homoleptische Komplex *fac*-Tris(2-phenylpyridyl-C²,N)iridium(III) (allgemein Ir(PPy)₃ genannt) unzersetzt bei der Herstellung der organischen Elektrolumineszenzvorrichtung aufgedampft werden. Allerdings wird dieser Aufdampfprozess mit nur geringen Aufdampfraten durchgeführt, während bei einer Sublimation zur Reinigung des Materials bei der Herstellung deutlich höhere Sublimationsraten und daher auch eine deutlich höhere Temperatur nötig sind. Die thermische Stabilität der Materialien bei der Sublimation ist noch nicht ausreichend, was zur partiellen Zersetzung des Materials führt, verbunden mit Verunreinigung des Komplexes durch zersetzte Komponenten.
2. Die operative Lebensdauer ist allgemein noch zu gering, was bislang noch der Einführung von phosphoreszierenden OLEDs in hochwertigen und langlebigen Vorrichtungen entgegensteht.
3. Insbesondere quadratisch-planare Komplexe neigen dazu, durch Stacking Exciplexe zu bilden, die die Emission entweder löschen oder die Emissionsfarbe ungewollt verschieben.
4. Die Komplexe besitzen häufig nur eine geringe Löslichkeit in organischen Lösemitteln, was eine effiziente Reinigung durch Umkristallisation oder Chromatographie stark erschwert oder verhindert. Dies gilt insbesondere für die Reinigung größerer Mengen, wie sie in der Displayfertigung benötigt werden. Gerade auch die bromierten Komplexe, die beispielsweise zur Herstellung von Polymeren verwendet werden können, zeigen nur eine geringe Löslichkeit und sind daher bei der Polymerisation schwer zu verarbeiten.

Besonders die gleichzeitige Verbesserung der Lebensdauer und der thermischen Stabilität der Komplexe wäre vorteilhaft. Es besteht daher der Bedarf an Verbindungen, die die oben genannten Schwachpunkte nicht aufweisen, die den bekannten Metallkomplexen jedoch in Bezug auf Effizienz und Emissionsfarbe mindestens gleichwertig sind.

Überraschend wurde nun gefunden, dass bestimmte neue Verbindungen, die eine Brücke mit genau einem Brückenatom zwischen den beiden Cyclen aufweisen, ausgezeichnete Eigenschaften als Triplettemitter in OLEDs besitzen.

Komplexe mit derartigen Liganden wurden bereits mit Rhodium erwähnt (JP 2004/311405, JP 2004/319438), wobei in den jeweiligen Anmeldungen auch etliche andere Rhodium-Komplexe, die diese Brücke nicht aufweisen bzw. die andere, größere Brücken aufweisen, abgebildet sind. Besondere Vorteile der Komplexe, die genau ein Brückenatom zwischen den beiden Cyclen aufweisen, gegenüber den anderen Komplexen sind nicht beschrieben. Diese Struktur ist nur als eine mögliche Ausführungsform neben etlichen anderen aufgeführt und lässt mit Rhodium keine besonderen Vorteile erkennen.

Gegenstand der vorliegenden Erfindung sind die Verbindungen gemäß Formel (1)

M(L)ₙ(L')ₘ(L")ₒ Formel (1)

enthaltend eine Teilstruktur M(L)ₙ gemäß Formel (2), 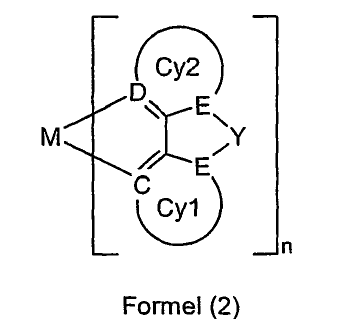 wobei für die verwendeten Symbole und Indizes gilt:
- M: ist bei jedem Auftreten Iridium, Platin, Palladium, Gold, Wolfram, Rhenium, Ruthenium oder Osmium;
- D: ist gleich oder verschieden bei jedem Auftreten ein sp²-hybridisiertes Heteroatom mit einem nicht-bindenden Elektronenpaar, das an M koordiniert;
- C: ist bei jedem Auftreten ein sp²-hybridisiertes Kohlenstoffatom, das an M bindet;
- E: ist gleich oder verschieden bei jedem Auftreten ein sp²-hybridisiertes Kohlenstoff- oder Stickstoffatom;
- Y: ist gleich oder verschieden bei jedem Auftreten CR₂, C(=O), C(=NR), C(=N-NR₂), C(=CR₂), SiR₂, O, S, S(=O), S(=O)₂, Se, NR, PR, P(=O)R, AsR, As(=O)R oder BR;
- Cy1: ist gleich oder verschieden bei jedem Auftreten ein gegebenenfalls durch R¹ substituierter Homo- oder Heterocyclus, der über ein sp²-hybridisiertes Kohlenstoffatom an M bindet;
- Cy2: ist gleich oder verschieden bei jedem Auftreten ein gegebenenfalls durch R¹ substituierter Heterocyclus, der über das Atom D an M koordiniert;
- R: ist gleich oder verschieden bei jedem Auftreten H, F, CN, eine geradkettige Alkyl- oder Alkoxygruppe mit 1 bis 40 C-Atomen oder eine verzweigte oder cyclische Alkyl- oder Alkoxygruppe mit 3 bis 40 C-Atomen, wobei jeweils eine oder mehrere nicht benachbarte CH₂-Gruppen durch -R²C=CR²-, -C≡C-, Si(R²)₂, Ge(R²)₂, Sn(R²)₂, -O-, -S-, -NR²-, -(C=O)-, -(C=NR²)-, -P=O(R²)- oder -CONR²- ersetzt sein können und wobei ein oder mehrere H-Atome durch F ersetzt sein können, oder ein aromatisches oder heteroaromatisches System bzw. eine Aryloxy- oder Heteroaryloxygruppe mit 1 bis 30 C-Atomen, welches jeweils durch einen oder mehrere Reste R¹ substituiert sein kann; dabei können auch zwei Reste R miteinander ein weiteres aliphatisches oder aromatisches Ringsystem bilden;
- R¹: ist gleich oder verschieden bei jedem Auftreten H, F, Cl, Br, I, OH, NO₂, CN, N(R²)_{2,} eine geradkettige Alkyl- oder Alkoxygruppe mit 1 bis 40 C-Atomen oder eine verzweigte oder cyclische Alkyl- oder Alkoxygruppe mit 3 bis 40 C-Atomen, wobei jeweils eine oder mehrere nicht benachbarte CH₂-Gruppen durch -R²C=CR²-, -C≡C-, Si(R²)₂, Ge(R²)₂, Sn(R²)₂, -O-, -S-, -NR²-, -(C=O)-, -(C=NR²)-, -P=O(R²)-, -COOR²- oder -CONR²- ersetzt sein können und wobei ein oder mehrere H-Atome durch F ersetzt sein können, oder ein aromatisches oder heteroaromatisches System bzw. eine Aryloxy- oder Heteroaryloxygruppe mit 1 bis 30 C-Atomen, welches durch einen oder mehrere nicht-aromatische Reste R¹ substituiert sein kann, wobei mehrere Substituenten R¹, sowohl am selben Ring als auch an unterschiedlichen Ringen zusammen wiederum ein weiteres mono- oder polycyclisches, aliphatisches oder aromatisches Ringsystem aufspannen können;
- R²: ist gleich oder verschieden bei jedem Auftreten H oder ein aliphatischer oder aromatischer Kohlenwasserstoffrest mit 1 bis 20 C-Atomen;
- n: ist 1, 2 oder 3;
dabei sind die Liganden L' und L" in Formel (1) monoanionische, zweizähnig chelatisierende Liganden; m und o sind gleich oder verschieden bei jedem Auftreten 0, 1 oder 2.

Dabei gilt, dass n + m + o = 2 für quadratisch-planar koordinierte Metalle, beispielsweise Platin und Palladium, und n + m + o = 3 für oktaedrisch koordinierte Metalle, beispielsweise Iridium, ist.

Unter Hybridisierung wird die Linearkombination von Atomorbitalen verstanden. So entstehen durch Linearkombination von einem 2s- und zwei 2p-Orbitalen drei äquivalente sp²-Hybridorbitale, die einen Winkel von 120° miteinander bilden. Das verbleibende p-Orbital ist zur Ausbildung einer π-Bindung, beispielsweise in einem aromatischen System, befähigt.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer C₁- bis C₄₀-Alkoxygruppe werden besonders bevorzugt Methoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen System mit 1-30 C-Atomen, welches noch jeweils mit den oben genannten Resten R¹ substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Tetracen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bevorzugt sind Cy1 und Cy2 aromatische bzw. heteroaromatische Systeme. Dabei können Cy1 und Cy2 auch mehrere Cyclen enthalten, die aneinander ankondensiert sind.

Bevorzugt sind Verbindungen gemäß Formel (1), enthaltend eine Teilstruktur M(L)ₙ gemäß Formel (2a), 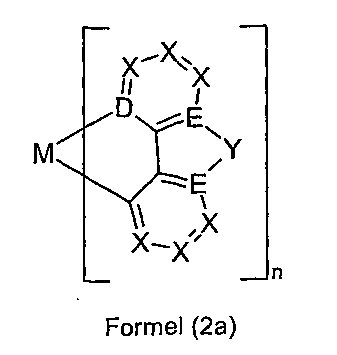 wobei M, Y, R, R¹, R², L', L" und n dieselbe Bedeutung haben, wie oben beschrieben, und für die weiteren Symbole gilt:
- D: ist gleich oder verschieden bei jedem Auftreten Stickstoff oder Phosphor;
- X: ist gleich oder verschieden bei jedem Auftreten CR¹, N oder P;
oder (X-X) bzw. (X=X) (also zwei benachbarte X) steht für NR¹, S oder O;
oder (X-X) bzw. (X=X) (also zwei benachbarte X) steht für CR¹, N oder P, falls das Symbol E im entsprechenden Cyclus für N steht;
- E: ist gleich oder verschieden bei jedem Auftreten C oder N mit der Maßgabe, dass, falls das Symbol E für N steht, genau eine Einheit X-X (also zwei benachbarte X) im entsprechenden Cyclus gleich CR¹, N oder P ist.

Eine besonders bevorzugte Ausführungsform der vorliegenden Erfindung sind Verbindungen der Formel (1 a),

M(L)ₙ(L')ₘ(L'')ₒ Formel (1a)

enthaltend mindestens eine Teilstruktur M(L)ₙ der Formel (2b), 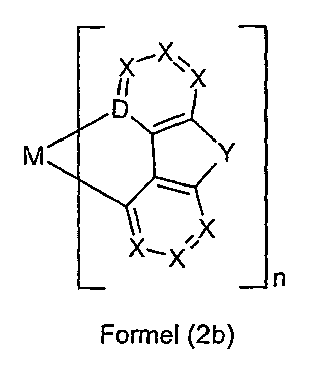 und gegebenenfalls enthaltend eine Teilstruktur M(L')ₘ der Formel (3), 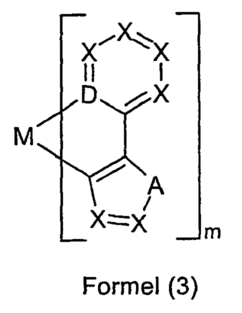 wobei M, D, R, R¹, R², L", n, m und o dieselbe Bedeutung haben, wie oben beschrieben, und weiterhin gilt:
- X: ist gleich oder verschieden bei jedem Auftreten CR¹, N oder P; oder (X-X) bzw. (X=X) (also zwei benachbarte X) steht für NR¹, S oder O;
- A: ist gleich oder verschieden bei jedem Auftreten -CR¹=CR¹-, -N=CR¹-, -P=CR¹-, -N=N-, -P=N-, NR¹, O oder S;
mit der Maßgabe, dass jeder der beiden Cyclen einen Fünf- oder einen Sechsring darstellt.

Erfindungsgemäße monoanionische, zweizähnige Liganden L" sind 1,3-Diketonate abgeleitet von 1,3-Diketonen, wie z. B. Acetylaceton, Benzoylaceton, 1,5-Diphenylacetylaceton, Bis(1,1,1-trifluoracetyl)methan, 3-Ketonate abgeleitet von 3-Ketoestern, wie z. B. Acetessigsäureethylester, Carboxylate abgeleitet von Aminocarbonsäuren, wie z. B. Pyridin-2-carbonsäure, Chinolin-2-carbonsäure, Glycin, N,N-Dimethylglycin, Alanin, N,N-Dimethylalanin, Salicyliminate abgeleitet von Salicyliminen, wie z. B. Methylsalicylimin, Ethylsalicylimin, Phenylsalicylimin, Liganden, die über ein neutrales und ein anionisches Stickstoffatom binden, wie z. B. Pyridyl-pyrazole, Pyridyl-imidazole oder Pyridyl-triazole, sowie Borate Stickstoff-haltiger Heterocyclen, wie z. B. Tetrakis(1-imidazolyl)borat und Tetrakis(1-pyrazolyl)borat.

Bevorzugt sind Verbindungen gemäß Formel (1) bzw. Formel (1a), bei denen für den Index n = 2 oder 3 gilt, wobei n = 3 für quadratisch-planare Komplexe nicht möglich ist. Besonders bevorzugt sind Verbindungen, bei denen für den Index o = 0 gilt. Ganz besonders bevorzugt sind Verbindungen, bei denen für die Indizes m = o = 0 gilt. Dabei gilt insbesondere, dass n = 2 und m = o = 0 für quadratisch-planare Komplexe und n = 3 und m = o = 0 für oktaedrische Komplexe bevorzugt ist. Ganz besonders bevorzugt sind homoleptische Komplexe, also Komplexe mit m = o = 0, bei denen alle vorhandenen Liganden gleich und auch gleich substituiert sind. Die Bevorzugung homoleptischer Komplexe ist durch die leichtere synthetische Zugänglichkeit zu begründen.

Bevorzugt sind Verbindungen gemäß Formel (1) bzw. Formel (1a), in denen das Symbol Y für CR₂, C(=O), C(=CR₂), O, S, NR, PR, P(=O)R oder BR steht. Besonders bevorzugt sind Verbindungen gemäß Formel (1) bzw. Formel (1a), in denen das Symbol Y für CR₂, O, S, NR oder P(=O)R steht.

In einer besonders bevorzugten Ausführungsform der Erfindung handelt es sich beim Liganden, der Strukturen gemäß Formel (2) bzw. Formel (2a) bzw. Formel (2b) erzeugt, um eine Spiroverbindung, wobei das Symbol Y das Spiroatom darstellt, insbesondere um Derivate des Azaspirobifluorens, also Strukturen, in denen das Symbol Y für CR₂ steht, wobei die beiden Reste R für substituierte oder unsubstituierte Phenylgruppen stehen, die miteinander ein weiteres Ringsystem bilden.

Bevorzugt sind weiterhin Verbindungen gemäß Formel (1) bzw. Formel (1a), bei denen für das Symbol D = N gilt.

Bevorzugt sind weiterhin Verbindungen gemäß Formel (1) bzw. Formel (1a), bei denen für das Symbol X = CR¹ oder N gilt, insbesondere X = CR¹.

Bevorzugt sind weiterhin Verbindungen gemäß Formel (1) bzw. Formel (1a), bei denen für das Symbol R¹ für aufdampfbare Systeme gilt:
R¹ ist bei jedem Auftreten gleich oder verschieden H, F, CN, Methyl, tert-Butyl, Phenyl, CF₃ oder eine ankondensierte cyclische Alkoxygruppe mit 1 bis 4 C-Atomen.

Für Verbindungen gemäß Formel (1) bzw. Formel (1a), die aus Lösung verarbeitet werden und die daher eine gute Löslichkeit in organischen Lösemitteln aufweisen müssen, enthält mindestens einer der Substituenten R und/oder R¹ eine Alkyl- und/oder Alkoxykette mit mindestens vier C-Atomen.

Insbesondere für quadratisch-planare Komplexe, also beispielsweise Komplexe mit Platin oder Palladium, ist es bevorzugt, wenn Y für CR₂ steht und die Reste R sterisch anspruchsvoll sind, beispielsweise ein Spiro-System darstellen, da die Komplexe dadurch sterisch abgeschirmt werden und die Bildung von Exciplexen verhindert wird.

Oktaedrische Verbindungen gemäß Formel (1) bzw. Formel (1a) können in facialer und meridionaler Form vorliegen. Gegenstand der Erfindung sind sowohl die reine faciale Form wie auch die reine meridionale Form des Komplexes oder auch Mischungen, in der sowohl die faciale wie auch die meridionale Form vorliegen.

Die entsprechenden Liganden, die Teilstrukturen gemäß Formel (2) bzw. Formel (2a) oder (2b) erzeugen, bzw. auch die Liganden L' und L" können nach gängigen organisch-chemischen Verfahren dargestellt werden, wie sie dem Fachmann der organischen Synthese geläufig sind. Dabei bieten sich für die Ligandensynthese von Azafluoren-Derivaten und entsprechenden Azaspirobifluoren-Derivaten, Azacarbazolen, etc. Reaktionen in Analogie zur Literatur an (z. B. A.-S. Rebstock et al., Tetrahedron 2003, 59, 4973-4977 für die Synthese von 4-Aza-9-fluorenon; T. lwaki et al., J. Chem. Soc., Perkin 1 1999, 1505-1510 für die Synthese von 4-Azacarbazol; A. Degl'Innocenti et al., J. Chem. Soc., Perkin 1 1996, 2561-2563 für die Synthese von 4-Aza-dibenzothiophen; W. S. Yue et al., Org. Lett. 2002, 4, 2201-2203 für die Synthese von 4-Aza-dibenzofuran). Azaspirobifluoren lässt sich aus Azafluorenon analog zur Synthese von Spirobifluoren aus Fluorenon synthetisieren.

Ein weiterer Gegenstand der Erfindung ist die Verwendung von Liganden, die im Komplex zu Teilstrukturen gemäß Formel (2) bzw. Formel (2a) bzw. Formel (2b) führen, zur Herstellung der erfindungsgemäßen Verbindungen gemäß Formel (1) bzw. Formel (1a).

Die erfindungsgemäßen Metallkomplexe sind prinzipiell durch verschiedene Verfahren darstellbar; es haben sich jedoch die im Folgenden beschriebenen Verfahren als besonders geeignet herausgestellt.

Daher ist ein weiterer Gegenstand der vorliegenden Erfindung ein Verfahren zur Herstellung der Metallkomplex-Verbindungen gemäß Formel (1) bzw. Formel (1a) durch Umsetzung der entsprechenden freien Liganden mit Metallalkoholaten der Formel (4), mit Metallketoketonaten der Formel (5) oder mit ein- oder mehrkernigen Metallhalogeniden der Formeln (6), (7) oder (8), 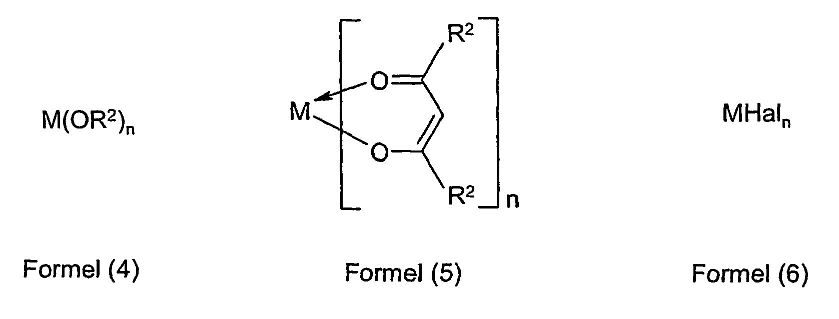 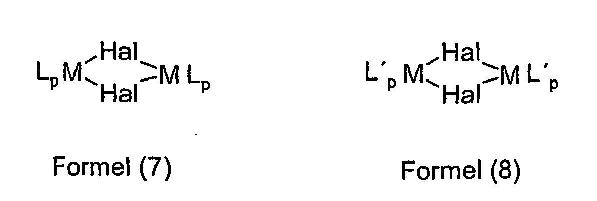 wobei die Symbole M, n und R² die oben angegebenen Bedeutungen haben, p = 1 für zweiwertige Metalle, p = 2 für dreiwertige Metalle und Hal = F, Cl, Br oder I ist.

Es können ebenfalls Metallverbindungen, insbesondere Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 04/085449 offenbart.

Die Synthese der Komplexe wird bevorzugt durchgeführt, wie in WO 02/060910 und in WO 04/085449 beschrieben. Heteroleptische Komplexe können beispielsweise auch gemäß WO 05/042548 synthetisiert werden.

Durch diese Verfahren lassen sich die erfindungsgemäßen Verbindungen gemäß Formel (1) in hoher Reinheit, bevorzugt mehr als 99 % (bestimmt mittels ¹H-NMR und/oder HPLC) erhalten.

Mit den hier erläuterten Synthesemethoden lassen sich unter anderem die im Folgenden dargestellten Strukturen (1) bis (159) für die Verbindungen gemäß Formel (1) herstellen.

| | | |
|---|---|---|
| 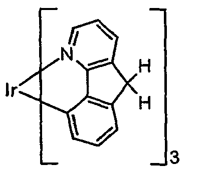 | 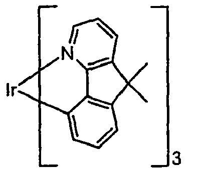 | 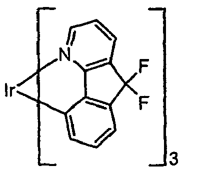 |
| (1) | (2) | (3) |
| 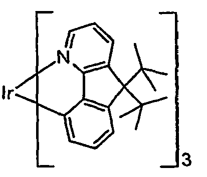 | 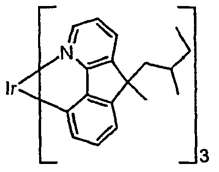 | 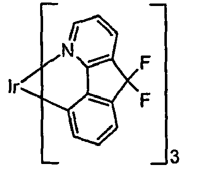 |
| (4) | (5) | (6) |
| 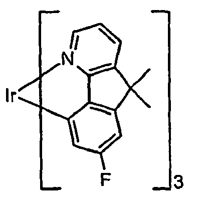 | 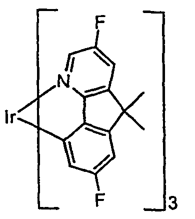 | 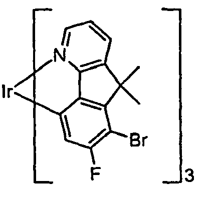 |
| (7) | (8) | (9) |
| 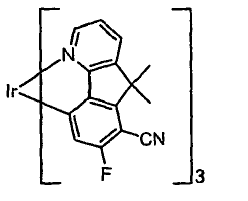 | 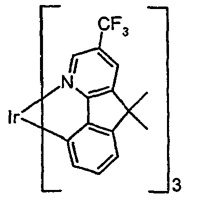 | 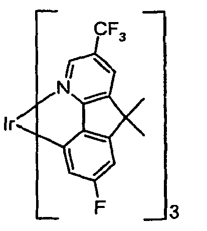 |
| (10) | (11) | (12) |
| 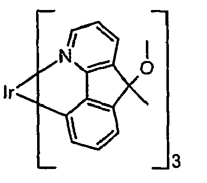 | 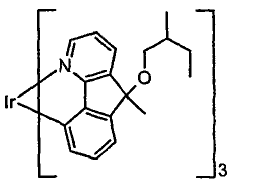 | 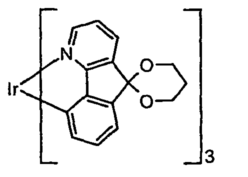 |
| (13) | (14) | (15) |
| 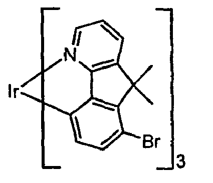 | 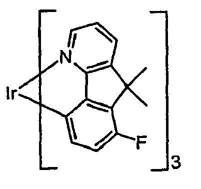 | 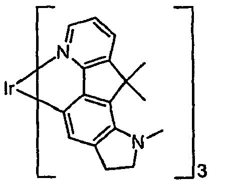 |
| (16) | (17) | (18) |
| 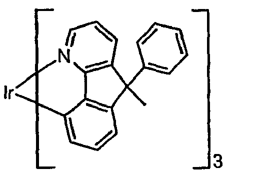 | 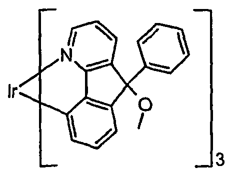 | 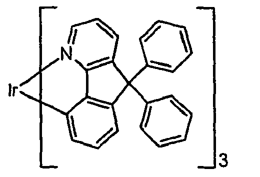 |
| (19) | (20) | (21) |
| 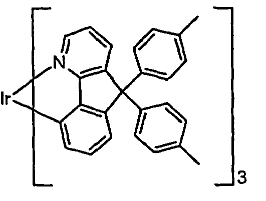 | 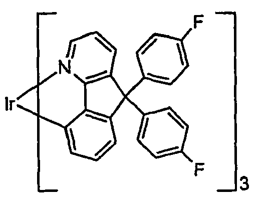 | 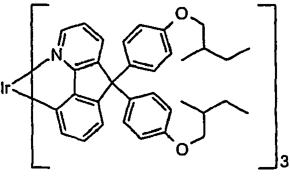 |
| (22) | (23) | (24) |
| 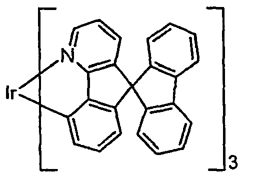 | 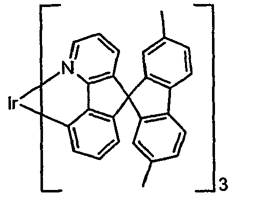 | 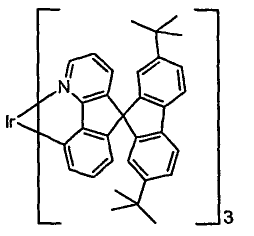 |
| (25) | (26) | (27) |
| 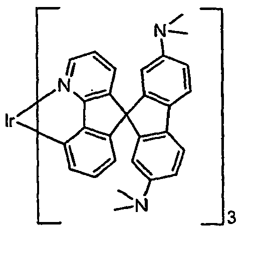 | 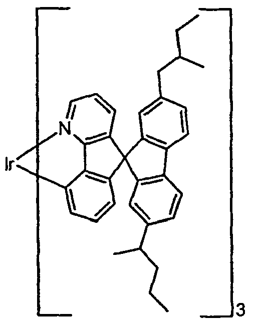 | 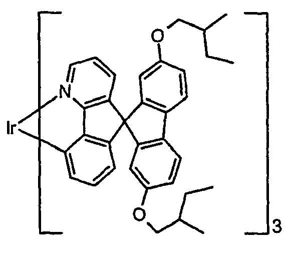 |
| (28) | (29) | (30) |
| 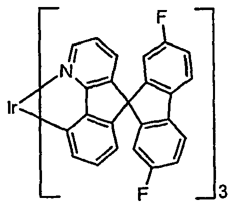 | 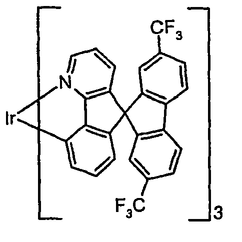 | 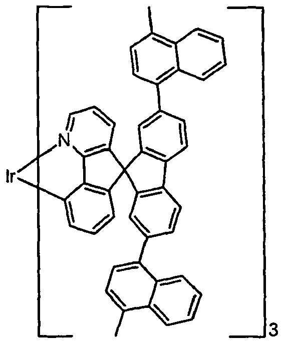 |
| (31) | (32) | (33) |
| 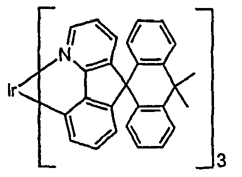 | 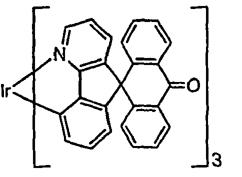 | 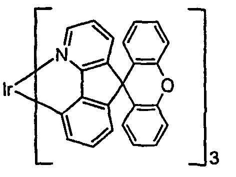 |
| (34) | (35) | (36) |
| 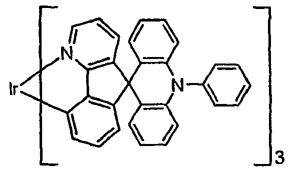 | 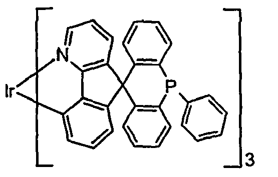 | 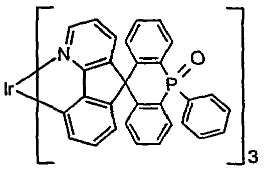 |
| (37) | (38) | (39) |
| 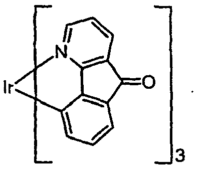 | 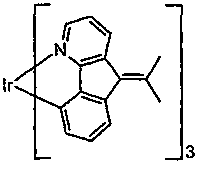 | 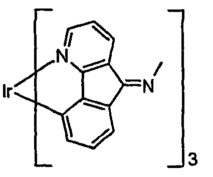 |
| (40) | (41) | (42) |
| 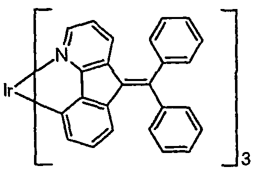 | 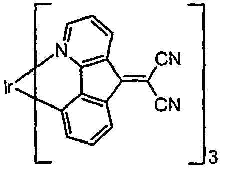 | 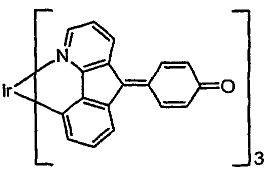 |
| (43) | (44) | (45) |
| 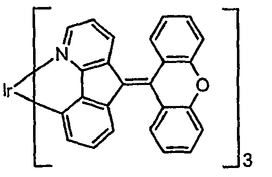 | 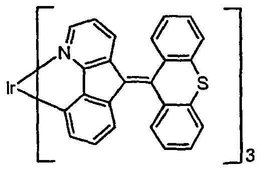 | 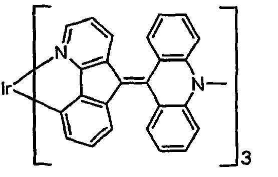 |
| (46) | (47) | (48) |
| 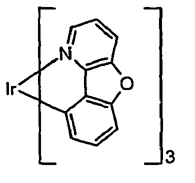 | 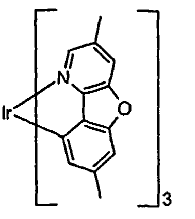 | 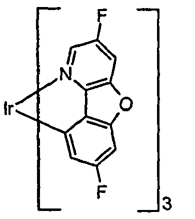 |
| (49) | (50) | (51) |
| 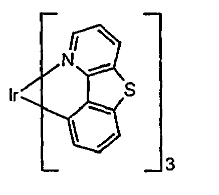 | 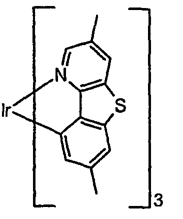 | 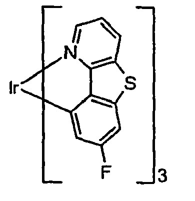 |
| (52) | (53) | (54) |
| 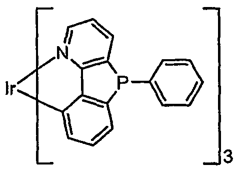 | 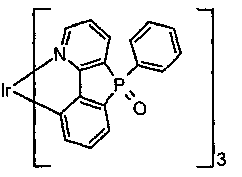 | 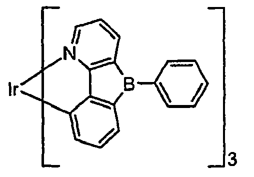 |
| (55) | (56) | (57) |
| 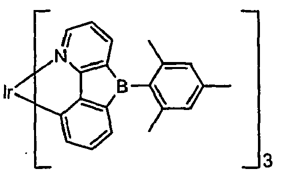 | 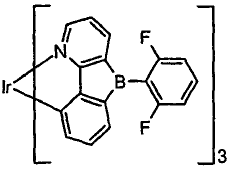 | 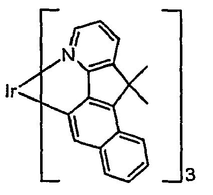 |
| (58) | (59) | (60) |
| 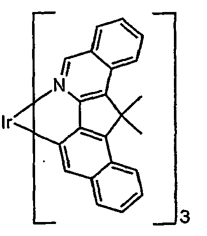 | 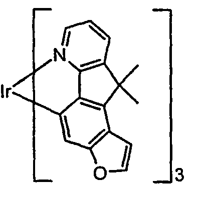 | 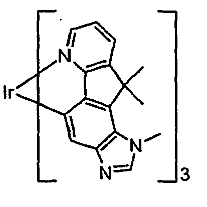 |
| (61) | (62) | (63) |
| 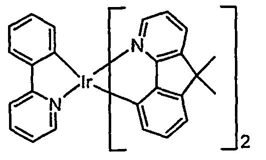 | 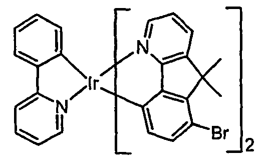 | 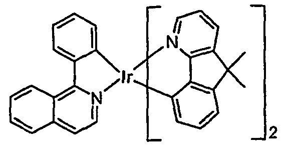 |
| (64) | (65) | (66) |
| 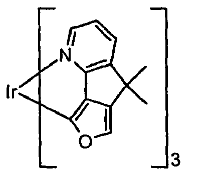 | 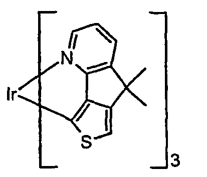 | 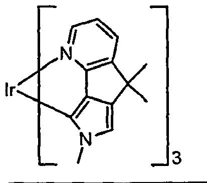 |
| (67) | (68) | (69) |
| 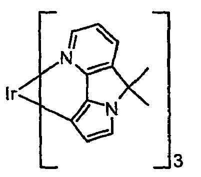 | 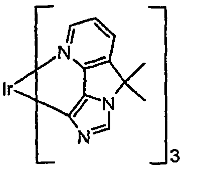 | 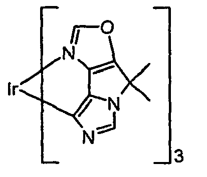 |
| (70) | (71) | (72) |
| 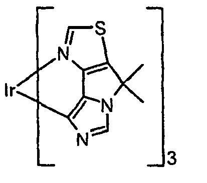 | 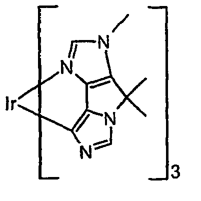 | 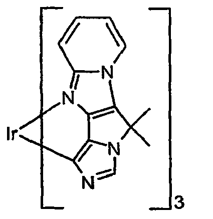 |
| (73) | (74) | (75) |
| 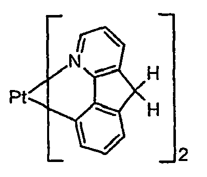 | 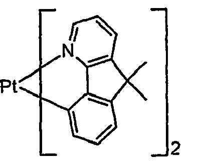 | 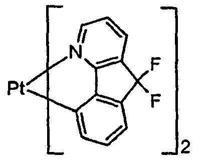 |
| (76) | (77) | (78) |
| 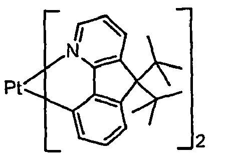 | 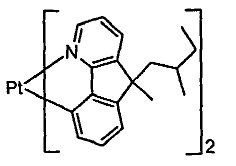 | 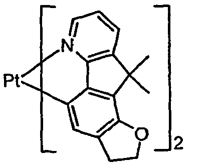 |
| (79) | (80) | (81) |
| 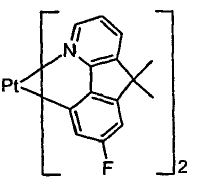 | 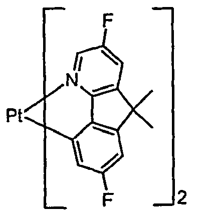 | 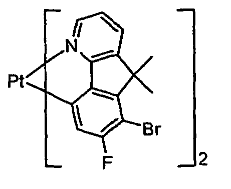 |
| (82) | (83) | (84) |
| 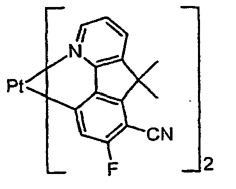 | 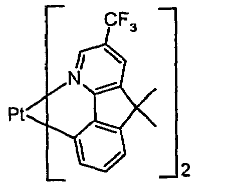 | 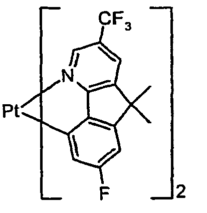 |
| (85) | (86) | (87) |
| 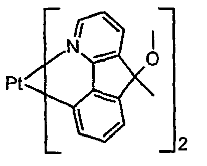 | 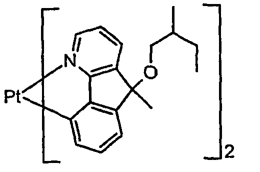 | 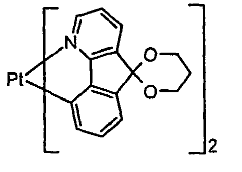 |
| (88) | (89) | (90) |
| 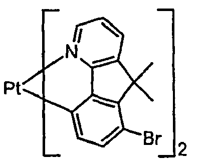 | 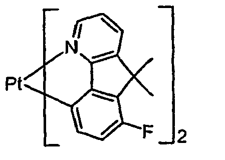 | 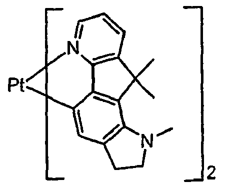 |
| (91) | (92) | (93) |
| 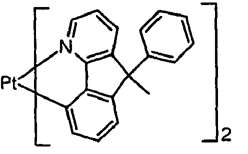 | 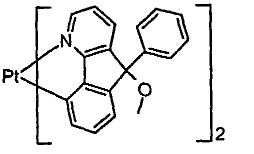 | 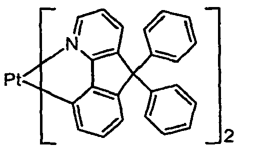 |
| (94) | (95) | (96) |
| 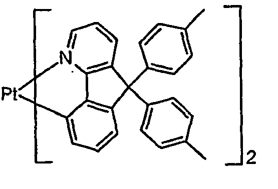 | 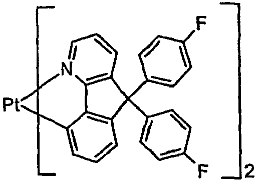 | 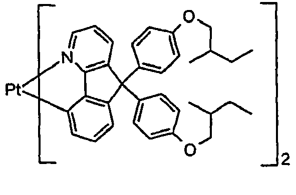 |
| (97) | (98) | (99) |
| 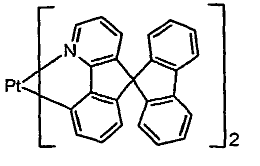 | 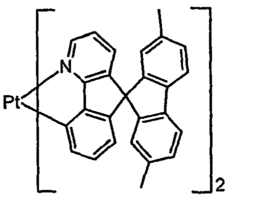 | 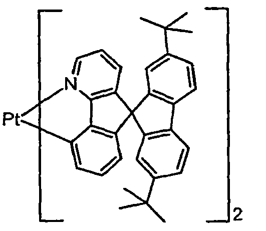 |
| (100) | (101) | (102) |
| 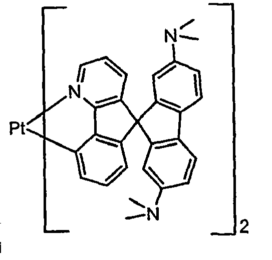 | 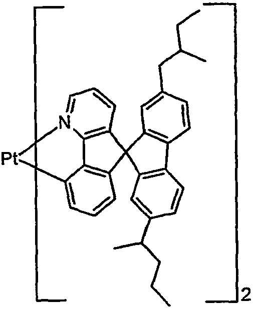 | 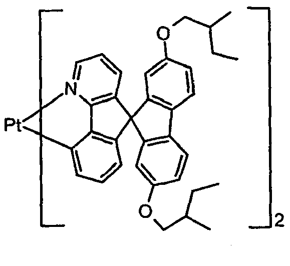 |
| (103) | (104) | (105) |
| 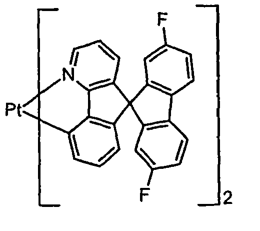 | 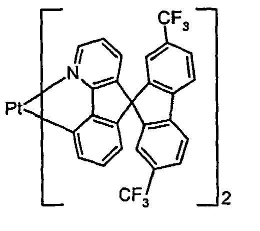 | 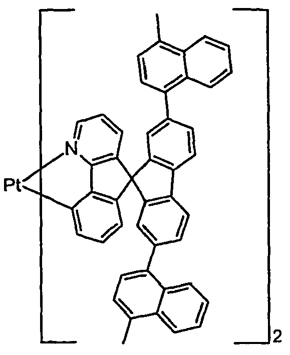 |
| (106) | (107) | (108) |
| 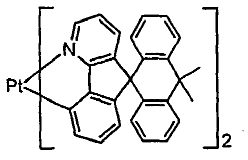 | 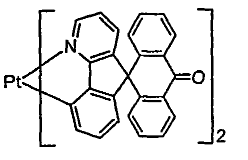 | 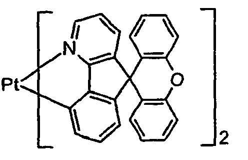 |
| (109) | (110) | (111) |
| 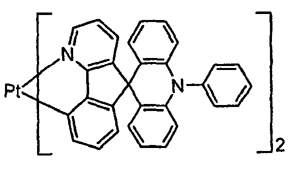 | 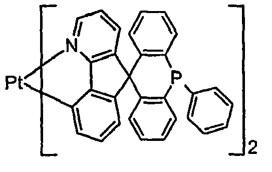 | 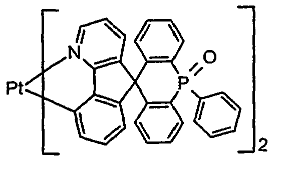 |
| (112) | (113) | (114) |
| 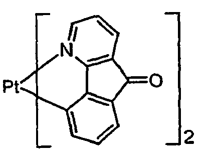 | 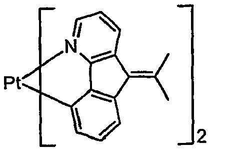 | 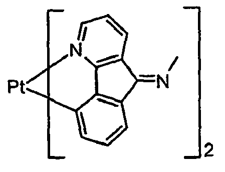 |
| (115) | (116) | (117) |
| 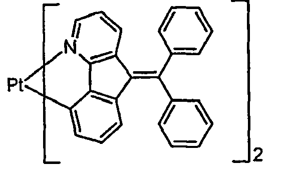 | 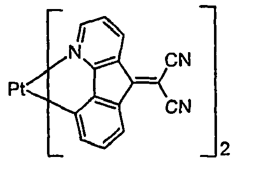 | 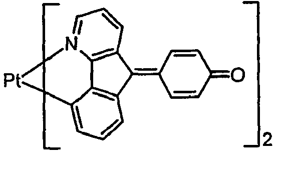 |
| (118) | (119) | (120) |
| 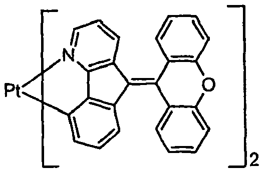 | 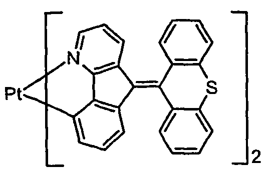 | 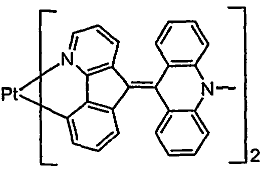 |
| (121) | (122) | (123) |
| 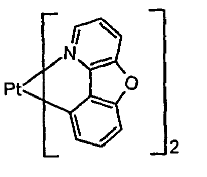 | 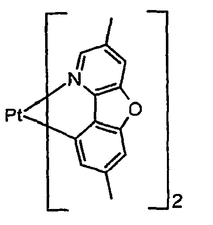 | 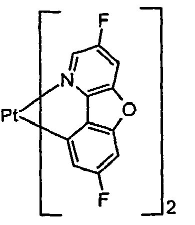 |
| (124) | (125) | (126) |
| 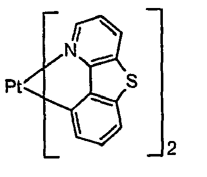 | 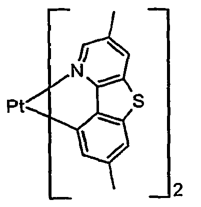 | 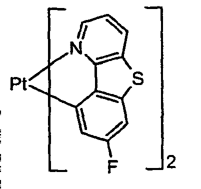 |
| (127) | (128) | (129) |
| 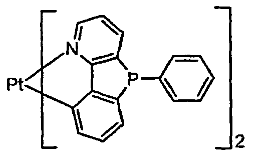 | 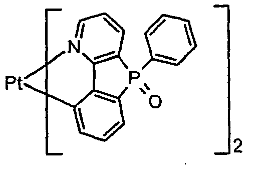 | 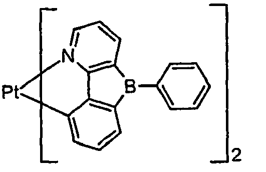 |
| (130) | (131) | (132) |
| 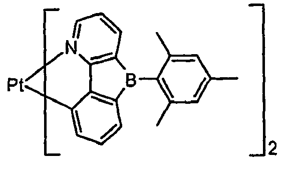 | 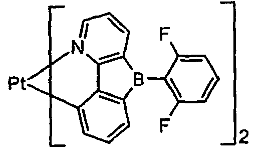 | 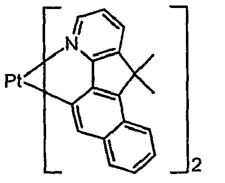 |
| (133) | (134) | (135) |
| 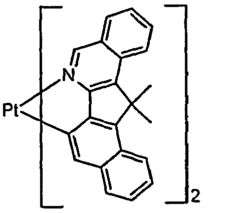 | 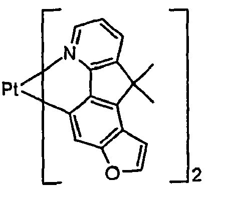 | 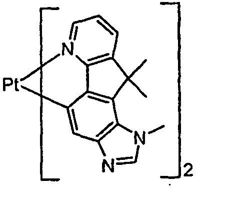 |
| (136) | (137) | (138) |
| 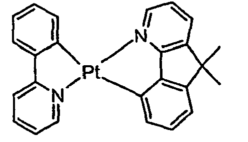 | 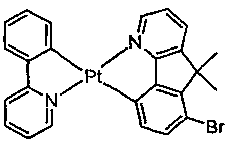 | 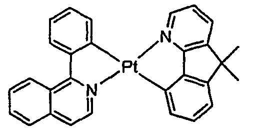 |
| (139) | (140) | (141) |
| 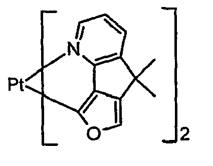 | 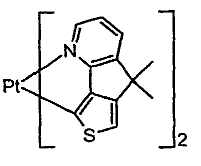 | 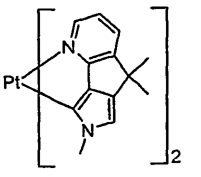 |
| (142) | (143) | (144) |
| 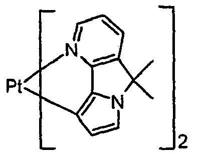 | 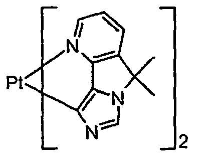 | 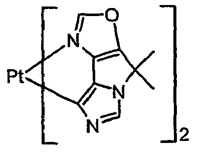 |
| (145) | (146) | (147) |
| 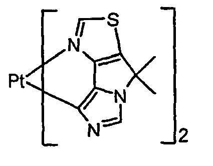 | 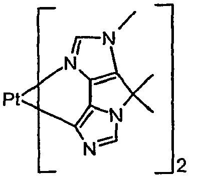 | 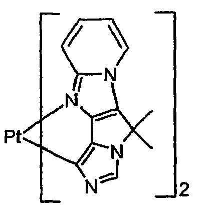 |
| (148) | (149) | (150) |
| 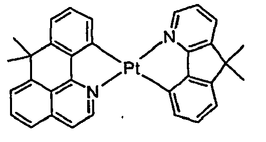 | 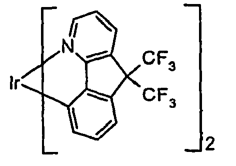 | 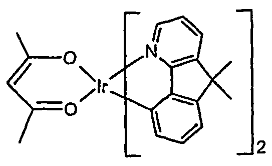 |
| (151) | (152) | (153) |
| 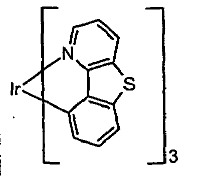 | 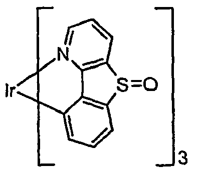 | 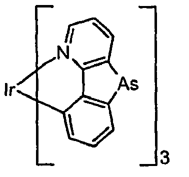 |
| (154) | (155) | (156) |
| 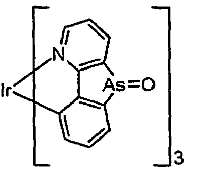 | 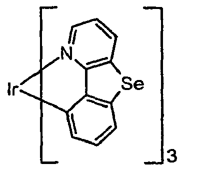 | 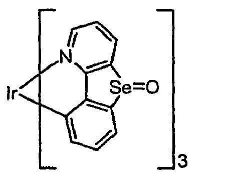 |
| (157) | (158) | (159) |

Die oben beschriebenen erfindungsgemäßen Verbindungen, z. B. Verbindungen gemäß den Beispielen 9, 16, 65, 84 und 91, können auch als Comonomere zur Erzeugung entsprechender konjugierter, teilkonjugierter oder nicht-konjugierter Oligomere, Polymere oder Dendrimere Verwendung finden. Die Polymerisation erfolgt dabei bevorzugt über die Bromfunktionalität. So können sie u. a. in Polyfluorene (z. B. gemäß EP 842208 oder WO 00/22026), Poly-spirobifluorene (z. B. gemäß EP 707020 oder EP 894107), Poly-dihydrophenanthrene (z. B. gemäß WO 05/014689), Poly-indenofluorene (z. B. gemäß WO 04/041901 und WO 041113468), Poly-phenanthrene (z. B. gemäß WO 05/104264), Poly-para-phenylene (z. B. gemäß WO 92/18552), Polycarbazole (z. B. gemäß WO 04/070772 oder WO 04/113468), Polyketone (z. B. gemäß WO 05/040302), Polysilane (z. B. gemäß DE 102004023278.4) oder Polythiophene (z. B. gemäß EP 1028136) einpolymerisiert werden oder auch in Copolymere, die verschiedene dieser Einheiten enthalten. Dabei können sie entweder in die Seitenkette oder in die Hauptkette des Polymers eingebaut werden oder können auch Verzweigungspunkte der Polymerketten (z. B. gemäß DE 102004032527.8) darstellen.

Weiterer Gegenstand der Erfindung sind somit konjugierte, teilkonjugierte oder nicht-konjugierte Oligomere, Polymere oder Dendrimere, enthaltend eine oder mehrere der Verbindungen gemäß Formel (1) bzw. Formel (1a), wobei mindestens einer der oben definierten Reste R bzw. R¹, bevorzugt R¹, eine Bindung zum Polymer oder Dendrimer darstellt. Für Einheiten gemäß Formel (1) bzw. Formel (1a) gelten in Polymeren und Dendrimeren dieselben Bevorzugungen, wie oben bereits beschrieben. Die Oligomere, Polymere oder Dendrimere können außer den oben aufgeführten Einheiten weitere Einheiten enthalten, die beispielsweise ausgewählt sind aus Wiederholeinheiten, die Lochtransporteigenschaften oder Elektronentransporteigenschaften aufweisen. Hierfür eignen sich die im Stand der Technik bekannten Materialien.

Die oben genannten Oligomere, Polymere, Copolymere und Dendrimere zeichnen sich durch ihre gute Löslichkeit in organischen Lösemitteln und hohe Effizienz und Stabilität in organischen elektrolumineszierenden Vorrichtungen aus.

Weiterhin können die erfindungsgemäßen Verbindungen gemäß Formel (1), insbesondere solche, die durch Halogene funktionalisiert sind, auch durch gängige Reaktionstypen weiter funktionalisiert werden und so zu erweiterten Verbindungen gemäß Formel (1) umgesetzt werden. Hier ist als Beispiel die Funktionalisierung mit Arylboronsäuren gemäß Suzuki oder mit Aminen gemäß Hartwig-Buchwald zu nennen.

Die erfindungsgemäßen Verbindungen, Oligomere, Polymere, Dendrimere oder erweiterten Verbindungen gemäß Formel (1) finden Verwendung als aktive Komponenten in organischen elektronischen Bauteilen, wie z. B. organischen Leuchtdioden (OLEDs), organischen integrierten Schaltungen (O-ICs), organischen Feld-Effekt-Transistoren (O-FETs), organischen Dünnfilmtransistoren (O-TFTs), organischen Solarzellen (O-SCs), organischen lichtemittierenden Transistoren (O-LETs), organischen Feld-Quench-Devices (O-FQDs), lichtemittierenden elektrochemischen Zellen (LECs) oder organischen Laserdioden (O-Laser).

Gegenstand der vorliegenden Erfindung ist also weiterhin die Verwendung der erfindungsgemäßen Verbindungen gemäß Formel (1), der erfindungsgemäßen Oligomere, Polymere und Dendrimere und entsprechender erweiterter Verbindungen gemäß Formel (1) als aktive Komponente in organischen elektronischen Bauteilen, insbesondere als emittierende Verbindung.

Weiterer Gegenstand der Erfindung sind elektronische Bauteile, ausgewählt aus der Gruppe der organischen und polymeren Leuchtdioden (OLEDs, PLEDs), organischen Feld-Effekt-Transistoren (O-FETs), organischen Dünnfilmtransistoren (O-TFTs), organischen integrierten Schaltungen (O-ICs), organischen Solarzellen (O-SCs), organischen lichtemittierenden Transistoren (O-LETs), organischen Feld-Quench-Devices (O-FQDs), lichtemittierenden elektrochemischen Zellen (LECs) und organischen Laserdioden (O-Laser), insbesondere organische und polymere Leuchtdioden, enthaltend eine oder mehrere erfindungsgemäße Verbindungen gemäß Formel (1), erfindungsgemäße Oligomere, Polymere und Dendrimere und entsprechende erweiterte Verbindungen gemäß Formel (1), insbesondere als emittierende Verbindung.

Insbesondere wenn es sich um niedermolekulare erfindungsgemäße Verbindungen handelt, werden diese in einer emittierenden Schicht üblicherweise zusammen mit einem Matrix-Material eingesetzt. Dabei kann das Matrixmaterial sowohl niedermolekular, wie auch oligomer oder polymer sein.

Bevorzugte Matrixmaterialien sind solche auf Basis von Carbazolen, beispielsweise CBP (Bis(carbazolyl)biphenyl), aber auch andere Materialien enthaltend Carbazol oder Carbazol-Derivate, z. B. gemäß WO 00/057676, EP 1202358 und WO 02/074015. Bevorzugt sind weiterhin Ketone und Imine, wie beispielsweise in WO 04/093207 beschrieben, insbesondere solche, basierend auf Spirobifluoren, und Phosphinoxide, Phosphinselenide, Phosphazene, Sulfoxide und Sulfone, wie beispielsweise in WO 05/003253 beschrieben, insbesondere solche, basierend auf Spirobifluoren. Weiterhin bevorzugt sind Silane, polypodale Metallkomplexe, z. B. gemäß WO 04/081017 und Oligophenylene basierend auf Spirobifluorenen, z. B. gemäß EP 676461 und WO 99/40051. Besonders bevorzugte Matrixmaterialien sind Ketone, Phosphinoxide, Sulfoxide und Sulfone. Ganz besonders bevorzugt sind Ketone und Phosphinoxide.

Die erfindungsgemäßen Verbindungen weisen die folgenden Vorteile gegenüber Verbindungen gemäß dem Stand der Technik auf:
1. Die erfindungsgemäßen Verbindungen zeichnen sich durch eine höhere Temperaturstabilität aus. So können die niedermolekularen Verbindungen nicht nur bei der Herstellung der organischen elektronischen Vorrichtung im Hochvakuum unzersetzt verdampft werden, sondern sie können auch zur Reinigung der Verbindungen mit größerer Rate bei höherer Temperatur unzersetzt sublimiert werden. Dadurch ist die ressourcenschonende Nutzung von Verbindungen dieser seltenen Metalle möglich.
2. Durch die sterische Abschirmung der Komplexe wird eine Triplett-Triplett-Annihilation vermieden, was zu höheren Effizienzen führt.
3. Die Lebensdauer der erfindungsgemäßen Komplexe bei Verwendung in OLEDs ist besser als von Komplexen gemäß dem Stand der Technik.
4. Die erfindungsgemäßen Verbindungen zeichnen sich durch eine gute Löslichkeit in organischen Lösungsmitteln aus, was ihre Reinigung durch gängige Verfahren wie Umkristallisation oder Chromatographie erheblich erleichtert. Damit sind die Verbindungen auch aus Lösung durch Beschichtungs- oder Drucktechniken verarbeitbar. Auch bei der üblichen Verarbeitung durch Verdampfen ist diese Eigenschaft von Vorteil, da so die Reinigung der Anlagen bzw. der eingesetzten Schattenmasken erheblich erleichtert wird.

Die vorliegende Erfindung wird durch die folgenden Beispiele näher erläutert, ohne sie darauf beschränken zu wollen. Der Fachmann kann aus den Schilderungen ohne erfinderisches Zutun weitere erfindungsgemäße Verbindungen herstellen bzw. das erfindungsgemäße Verfahren anwenden.

### Beispiele:

4-Azafluorenon (A.-S. Rebstock et al., Tetrahedron 2003, 59, 4973, M. T. DuPriest et al., J. Org. Chem. 1986, 51, 2021), 4-Azafluoren (M. T. DuPriest et al., J. Org. Chem. 1986, 51, 2021), Benzofuro[3,2-b]pyridin (J. Org. Chem. 1983, 48(5), 690) und [1]Benzothieno[3,2-b]pyridin (J. Chem. Soc., Perkin. Trans., 1996, 21, 2561) wurden gemäß der Literatur synthetisiert. Natrium(bis(acetylacetonato)dichloro)iridat(III) wurde gemäß der nicht offen gelegten Anmeldung EP 04019737.1 synthetisiert.

### Beispiel 1: fac-Tris(4-azafluorenyl-κN,κC)iridium(III)

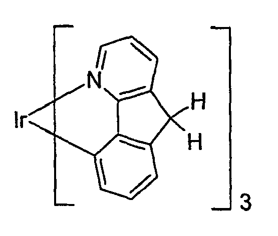

Eine Suspension von 484 mg (1.0 mmol) Natrium(bis(acetylacetonato)-dichloro)-iridat(III) und 1.00 g (6.0 mmol) 4-Azafluoren in 5 ml Ethylenglycol wird 150 h auf 180 °C erhitzt. Nach Erkalten auf 60 °C wird ein Gemisch von 25 ml 1 N wässriger Salzsäure und 25 ml Ethanol zugegeben. Der ausgefallene Feststoff wird abgesaugt, dreimal mit 10 ml Wasser und dreimal mit 10 ml Ethanol gewaschen und anschließend im Vakuum getrocknet. Ausbeute: 243 mg (0.4 mmol), 35.2 % d. Th.; Reinheit: 99.5 %ig nach NMR.

### Beispiel 2: fac-Tris(9,9'-dimethyl-4-azafluorenyl-κN,κC)iridium(III)

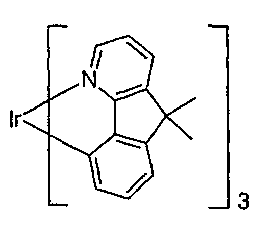

**a) 9,9'-Dimethyl-4-azafluoren**
   16.7 g (100 mmol) 4-Azafluoren und 38.4 g (400 mmol) Natrium-tert-butylat werden in 300 ml DMF suspendiert. Die Suspension wird 30 min. bei 60 °C gerührt und dann tropfenweise mit 12.8 ml (205 mmol) Methyliodid versetzt. Nach 6 h Rühren bei 60 °C wird mit 500 ml Wasser versetzt, der ausgefallene Feststoff wird abfiltriert, dreimal mit 100 ml Wasser und dreimal mit 50 ml Ethanol gewaschen, getrocknet und anschließend einmal aus DMF (1.5 ml / g) umkristallisiert. Ausbeute: 14.3 g (73 mmol), 73.2 % d. Th.; Reinheit: 99 %ig nach NMR.
**b) *fac*-Tris(9,9'-dimethyl-4-azafluorenyl-**κ***N*,**κ***C*)iridium(III)** Durchführung analog Beispiel 1. Ansatz: 484 mg (1.0 mmol) Natrium(bis(acetylacetonato)dichloro)iridat(III), 1.17 g (6.0 mmol) 9,9'-Dimethyl-4-azafluoren. Ausbeute: 322 mg (0.4 mmol), 41.5 % d. Th.; Reinheit: 99.5 %ig nach NMR.

### Beispiel 3: fac-Tris(spiro(bifluoren-9,9'-(4-azafluorenyl))-κN,κC)iridium(III)

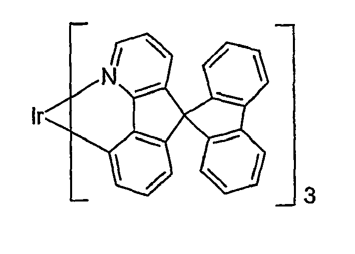

**a) Spiro-bifluoren-9,9'-(4-azafluoren)**
   Aus 19.0 ml (110 mmol) 2-Brombiphenyl und 2.7 g (112 mmol) Magnesium in einem Gemisch aus 100 ml THF und 50 ml 1,2-Dimethoxyethan wird das entsprechende Gringard-Reagenz dargestellt. Diese Lösung wird zu einer Suspension von 18.1 g (100 mmol) 4-Azafluorenon in THF getropft. Die so erhaltene Mischung wird 3 h bei 50 °C und dann 15 h bei Raumtemperatur gerührt. Der ausgefallene Feststoff wird abgesaugt, mit wenig Diethylether gewaschen und in ein Gemisch aus 300 ml Essigsäure und 15 ml konz. Schwefelsäure eingetragen. Diese Mischung wird 5 h unter Rückfluss gekocht, die Essigsäure wird abdestilliert und der Rückstand mit 200 ml Wasser versetzt. Nach Zugabe von 500 ml Dichlormethan wird die wässrige Phase mit gesättigter Kaliumcarbonatlösung alkalisch (pH > 10) gestellt, die Dichlormethanphase wird abgetrennt, die wässrige Phase wird erneut mit 200 ml Dichlormethan extrahiert. Die vereinigten organischen Phasen werden nach Trocknen über Magnesiumsulfat eingeengt. Der so erhaltene ölige Rückstand wird an Kieselgel mit Dichlormethan/Methanol/Essigsäure (1500:100:1) chromatographiert. Ausbeute: 13.0 g (41 mmol), 41.1 % d. Th.; Reinheit: 99 %ig nach NMR.
**b) *fac*-Tris(spiro(bifluoren-9,9'-(4-azafluorenyl))-**κ***N*,**κ**C)iridium(III)** Durchführung analog Beispiel 1. Ansatz: 484 mg (1.0 mmol) Natrium(bis(acetylacetonato)dichloro)iridat(III), 1.90 g (6.0 mmol) Spirobifluoren-9,9'-(4-azafluoren). Ausbeute: 335 mg (0.3 mmol), 29.4 % d. Th.; Reinheit: 99.5 %ig nach NMR.

### Beispiel 4: fac-Tris(benzofuro[3,2-b]pyridinyl-κN,κC)iridium(III)

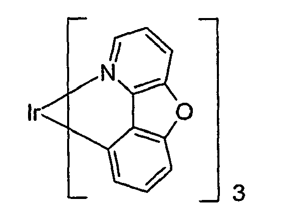

Durchführung analog Beispiel 1. Ansatz: 484 mg (1.0 mmol) Natrium(bis(acetylacetonato)dichloro)iridat(III), 1.02 g (6.0 mmol) Benzofuro[3,2-b]pyridin. Ausbeute: 403 mg (0.6 mmol), 57.8 % d. Th.; Reinheit: 99.5 %ig nach NMR.

### Beispiel 5: fac-Tris([1]benzothieno[3,2-b]pyridinyl-κN,κC)iridium(III)

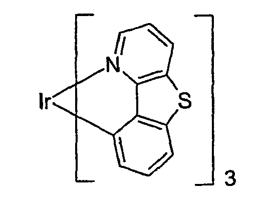

Durchführung analog Beispiel 1. Ansatz: 484 mg (1.0 mmol) Natrium(bis(acetylacetonato)dichloro)iridat(III), 1.11 g (6.0 mmol) [1]Benzothieno[3,2-b]pyridin. Ausbeute: 458 mg (0.6 mmol), 61.5 % d. Th.; Reinheit: 99.5 %ig nach NMR.

## Patentansprüche

1. Verbindungen gemäß Formel (1)
M(L)ₙ(L')ₘ(L")ₒ Formel (1)
enthaltend eine Teilstruktur M(L)ₙ gemäß Formel (2), 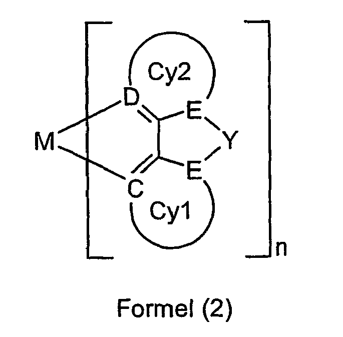 wobei für die verwendeten Symbole und Indizes gilt:
M ist bei jedem Auftreten Iridium, Platin, Palladium, Gold, Wolfram, Rhenium, Ruthenium oder Osmium;
D ist gleich oder verschieden bei jedem Auftreten ein sp²-hybridisiertes Heteroatom mit einem nicht-bindenden Elektronenpaar, das an M koordiniert;
C ist bei jedem Auftreten ein sp²-hybridisiertes Kohlenstoffatom, das an M bindet;
E ist gleich oder verschieden bei jedem Auftreten ein sp²-hybridisiertes Kohlenstoff- oder Stickstoffatom;
Y ist gleich oder verschieden bei jedem Auftreten CR₂, C(=O), C(=NR), C(=N-NR₂), C(=CR₂), SiR₂, O, S, S(=O), S(=O)₂, Se, NR, PR, P(=O)R, AsR, As(=O)R oder BR;
Cy1 ist gleich oder verschieden bei jedem Auftreten ein gegebenenfalls durch R¹ substituierter Homo- oder Heterocyclus, der über ein sp²-hybridisiertes Kohlenstoffatom an M bindet;
Cy2 ist gleich oder verschieden bei jedem Auftreten ein gegebenenfalls durch R¹ substituierter Heterocyclus, der über das Atom D an M koordiniert;
R ist gleich oder verschieden bei jedem Auftreten H, F, CN, eine geradkettige Alkyl- oder Alkoxygruppe mit 1 bis 40 C-Atomen oder eine verzweigte oder cyclische Alkyl- oder Alkoxygruppe mit 3 bis 40 C-Atomen, wobei jeweils eine oder mehrere nicht benachbarte CH₂-Gruppen durch -R²C=CR²-, -C=C-, Si(R²)₂, Ge(R²)₂, Sn(R²)₂, -O-, -S-, -NR²-, -(C=O)-, -(C=NR²)-, -P=O(R²)- oder -CONR²- ersetzt sein können und wobei ein oder mehrere H-Atome durch F ersetzt sein können, oder ein aromatisches oder heteroaromatisches System bzw. eine Aryloxy- oder Heteroaryloxygruppe mit 1 bis 30 C-Atomen, welches durch einen oder mehrere Reste R¹ substituiert sein kann; dabei können auch zwei Reste R miteinander ein weiteres aliphatisches oder aromatisches Ringsystem bilden;
R¹ ist gleich oder verschieden bei jedem Auftreten H, F, Cl, Br, I, OH, NO₂, CN, N(R²)₂, eine geradkettige Alkyl- oder Alkoxygruppe mit 1 bis 40 C-Atomen oder eine verzweigte oder cyclische Alkyl- oder Alkoxygruppe mit 3 bis 40 C-Atomen, wobei jeweils eine oder mehrere nicht benachbarte CH₂-Gruppen durch -R²C=CR²-, -C≡C-, Si(R²)₂, Ge(R²)₂, Sn(R²)₂, -O-, -S-, -NR²- -(C=O)-, -(C=NR²)-, -P=O(R²)-, -COOR²- oder -CONR²- ersetzt sein können und wobei ein oder mehrere H-Atome durch F ersetzt sein können, oder ein aromatisches oder heteroaromatisches System bzw. eine Aryloxy- oder Heteroaryloxygruppe mit 1 bis 30 C-Atomen, welches jeweils durch einen oder mehrere nicht-aromatische Reste R¹ substituiert sein kann, wobei mehrere Substituenten R¹, sowohl am selben Ring als auch an unterschiedlichen Ringen zusammen wiederum ein weiteres mono- oder polycyclisches, aliphatisches oder aromatisches Ringsystem aufspannen können;
R² ist gleich oder verschieden bei jedem Auftreten H oder ein aliphatischer oder aromatischer Kohlenwasserstoffrest mit 1 bis 20 C-Atomen;
n ist 1, 2 oder 3;
dabei sind die Liganden L' und L" in Formel (1) monoanionische, zweizähnig chelatisierende Liganden; m und o sind gleich oder verschieden bei jedem Auftreten 0, 1 oder 2.

2. Verbindungen gemäß Anspruch 1, **dadurch gekennzeichnet, dass** Cy1 und Cy2 aromatische bzw. heteroaromatische Systeme darstellen.

3. Verbindungen gemäß Anspruch 2, enthaltend eine Teilstruktur M(L)ₙ gemäß Formel (2a), 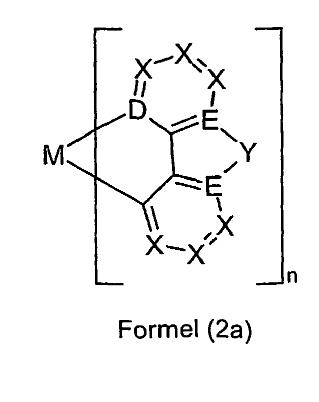 wobei M, Y, R, R¹, R², L', L" und n dieselbe Bedeutung haben, wie oben beschrieben, und für die weiteren Symbole gilt:
D ist gleich oder verschieden bei jedem Auftreten Stickstoff oder Phosphor;
X ist gleich oder verschieden bei jedem Auftreten CR¹, N oder P;
oder (X-X) bzw. (X=X) (also zwei benachbarte X) steht für NR¹, S oder O;
oder (X-X) bzw. (X=X)
(also zwei benachbarte X) steht für CR¹, N oder P, falls das Symbol E im entsprechenden Cyclus für N steht;
E ist gleich oder verschieden bei jedem Auftreten C oder N mit der Maßgabe, dass, falls das Symbol E für N steht, genau eine Einheit X-X (also zwei benachbarte X) im entsprechenden Cyclus gleich CR¹, N oder P ist.

4. Verbindungen der Formel (1a) gemäß Anspruch 3,
M(L)ₙ(L')ₘ(L")ₒ Formel (1a)
enthaltend mindestens eine Teilstruktur M(L)ₙ der Formel (2b), 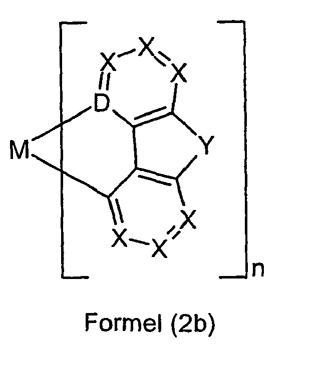 und gegebenenfalls enthaltend eine Teilstruktur M(L')ₘ der Formel (3), 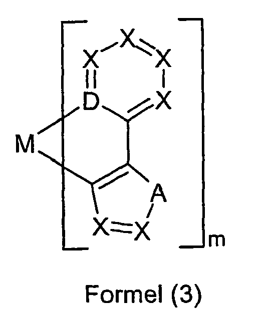 wobei M, D, R, R¹, R², L", n, m und o dieselbe Bedeutung haben, wie oben beschrieben, und weiterhin gilt:
X ist gleich oder verschieden bei jedem Auftreten CR¹, N oder P;
oder (X-X) bzw. (X=X) (also zwei benachbarte X) steht für NR¹, S oder O;
A ist gleich oder verschieden bei jedem Auftreten -CR¹=CR¹-, -N=CR¹-, -P=CR¹-, -N=N-, -P=N-, NR¹, O oder S;
mit der Maßgabe, dass jeder der beiden Cyclen einen Fünf- oder einen Sechsring darstellt.

5. Verbindungen gemäß einem oder mehreren der Ansprüche 1 bis 4, **dadurch gekennzeichnet, dass** monoanionische, zweizähnige Liganden L" ausgewählt sind aus der Gruppe der 1,3-Diketonate abgeleitet von 1,3-Diketonen, der 3-Ketonate abgeleitet von 3-Ketoestern, der Carboxylate abgeleitet von Aminocarbonsäuren, der Salicyliminate abgeleitet von Salicyliminen, sowie der Borate Stickstoff-haltiger Heterocyclen.

6. Verbindungen gemäß einem oder mehreren der Ansprüche 1 bis 5, **dadurch gekennzeichnet, dass** für den Index n = 2 oder 3 gilt.

7. Verbindungen gemäß Anspruch 6, **dadurch gekennzeichnet, dass** für die Indizes m = o = 0 gilt.

8. Verbindungen gemäß einem oder mehreren der Ansprüche 1 bis 7, **dadurch gekennzeichnet, dass** das Symbol Y für CR₂, C(=O), C(=CR₂), O, S, NR, PR, P(=O)R oder BR steht.

9. Verbindungen gemäß Anspruch 8, **dadurch gekennzeichnet, dass** es sich bei dem Liganden, der Strukturen gemäß Formel (2) bzw. Formel (2a) bzw. Formel (2b) erzeugt, um eine Spiroverbindung handelt, wobei das Symbol Y für CR₂ steht und das Spiroatom darstellt, insbesondere um Derivate des Azaspirobifluorens.

10. Verbindungen gemäß einem oder mehreren der Ansprüche 1 bis 9, **dadurch gekennzeichnet, dass** für das Symbol D = N gilt.

11. Verbindungen gemäß einem oder mehreren der Ansprüche 1 bis 10, **dadurch gekennzeichnet, dass** für das Symbol X = CR¹ gilt.

12. Verwendung von Liganden, die im Komplex zu Teilstrukturen gemäß Formel (2) gemäß Anspruch 1 bzw. Formel (2a) gemäß Anspruch 3 bzw. Formel (2b) gemäß Anspruch 4 führen, zur Herstellung der Verbindungen gemäß Formel (1) gemäß Anspruch 1 bzw. Formel (1a) gemäß Anspruch 4.

13. Verfahren zur Herstellung der Verbindungen gemäß einem oder mehreren der Ansprüche 1 bis 11 durch Umsetzung der entsprechenden freien Liganden mit Metallalkoholaten der Formel (4), mit Metallketoketonaten der Formel (5) oder ein- oder mehrkernigen Metallhalogeniden der Formeln (6), (7) oder (8), 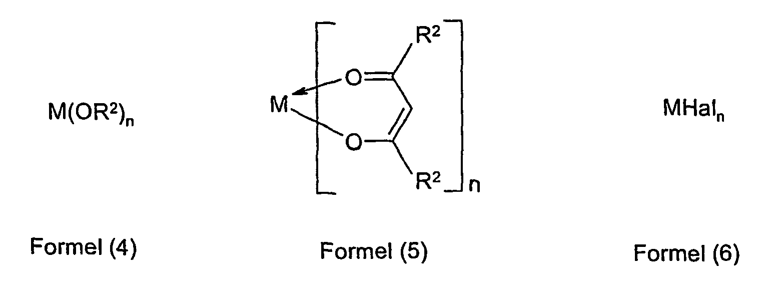 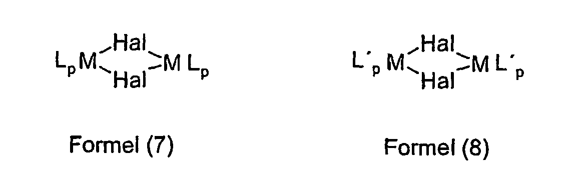 wobei die Symbole M, n und R² die in Anspruch 1 angegebenen Bedeutungen haben, p = 1 für zweiwertige Metalle, p = 2 für dreiwertige Metalle und Hal = F, Cl, Br oder I ist.

14. Verfahren gemäß Anspruch 13, **dadurch gekennzeichnet, dass** Metallverbindungen, die sowohl Alkoholat- und/oder Halogenid- und/oder Hydroxy- wie auch Ketoketonatreste tragen, verwendet werden und dass diese Verbindungen auch geladen sein können.

15. Konjugierte, teilkonjugierte oder nicht-konjugierte Oligomere, Polymere oder Dendrimere, enthaltend eine oder mehrere der Verbindungen gemäß einem oder mehreren der Ansprüche 1 bis 11, wobei mindestens einer der oben definierten Reste R bzw. R¹, bevorzugt R¹, eine Bindung zum Polymer oder Dendrimer darstellt.

16. Polymere gemäß Anspruch 15, **dadurch gekennzeichnet, dass** sie ausgewählt sind aus den Klassen der Polyfluorene, Poly-spirobifluorene, Poly-dihydrophenanthrene, Poly-indenofluorene, Poly-phenanthrene, Poly-para-phenylene, Polycarbazole, Polyketone, Polysilane oder Polythiophene oder auch Copolymere, die verschiedene dieser Einheiten enthalten.

17. Verwendung von Verbindungen, Oligomeren, Polymeren und/oder Dendrimeren gemäß einem oder mehreren der Ansprüche 1 bis 11 und/oder 15 bis 16 in organischen elektronischen Bauteilen.

18. Organische elektronische Bauteile, enthaltend eine oder mehrere Verbindungen, Oligomere, Polymere und/oder Dendrimere gemäß einem oder mehreren der Ansprüche 1 bis 11 und/oder 15 bis 16.

19. Organische elektronische Vorrichtung gemäß Anspruch 18, ausgewählt aus der Gruppe der organischen und polymeren Leuchtdioden (OLEDs, PLEDs), organischen Feld-Effekt-Transistoren (O-FETs), organischen Dünnfilmtransistoren (O-TFTs), organischen integrierten Schaltungen (O-ICs), organischen Solarzellen (O-SCs), organischen lichtemittierenden Transistoren (O-LETs), organischen Feld-Quench-Devices (O-FQDs), lichtemittierenden elektrochemischen Zellen (LECs) und organischen Laserdioden (O-Laser).

## Claims

1. Compounds of the formula (1)
M(L)ₙ(L')ₘ(L")ₒ formula (1)
containing a sub-structure M(L)ₙ of the formula (2) 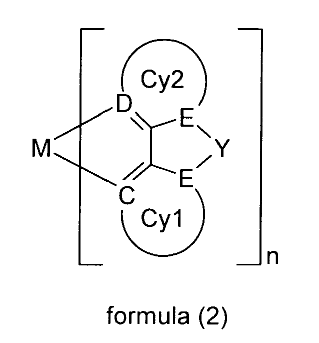 where the following applies to the symbols and indices used:
M is on each occurrence iridium, platinum, palladium, gold, tungsten, rhenium, ruthenium or osmium;
D is, identically or differently on each occurrence, an sp²-hybridised heteroatom having a non-bonding electron pair which coordinates to M;
C is on each occurrence an sp²-hybridised carbon atom which bonds to M;
E is, identically or differently on each occurrence, an sp²-hybridised carbon or nitrogen atom;
Y is, identically or differently on each occurrence, CR₂, C(=O), C(=NR), C(=N-NR₂), C(=CR₂), SiR₂, O, S, S(=O), S(=O)₂, Se, NR, PR, P(=O)R, AsR, As(=O)R or BR;
Cy1 is, identically or differently on each occurrence, an optionally R¹-substituted homo- or heterocycle which bonds to M via an sp²-hybridised carbon atom;
Cy2 is, identically or differently on each occurrence, an optionally R¹-substituted heterocycle which coordinates to M via the atom D;
R is, identically or differently on each occurrence, H, F, CN, a straight-chain alkyl or alkoxy group having 1 to 40 C atoms or a branched or cyclic alkyl or alkoxy group having 3 to 40 C atoms, where in each case one or more non-adjacent CH₂ groups may be replaced by -R²C=CR²-, -C≡C-, Si(R²)₂, Ge(R²)_{2,} Sn(R²)₂, -O-, -S-, -NR²-, -(C=O)-, -(C=NR²)-, -P=O(R²)- or -CONR²- and where one or more H atoms may be replaced by F, or an aromatic or heteroaromatic system or an aryloxy or heteroaryloxy group having 1 to 30 C atoms, which may be substituted by one or more radicals R¹; two radicals R here may also form a further aliphatic or aromatic ring system with one another;
R¹ is, identically or differently on each occurrence, H, F, Cl, Br, I, OH, NO₂, CN, N(R²)_{2,} a straight-chain alkyl or alkoxy group having 1 to 40 C atoms or a branched or cyclic alkyl or alkoxy group having 3 to 40 C atoms, where in each case one or more non-adjacent CH₂ groups may be replaced by -R²C=CR²-, -C≡C-, Si(R²)₂, Ge(R²)₂, Sn(R²)₂, -O-, -S-, -NR²-, -(C=O)-, -(C=NR²)-, -P=O(R²)-, -COOR²- or -CONR²- and where one or more H atoms may be replaced by F, or an aromatic or heteroaromatic system or an aryloxy or heteroaryloxy group having 1 to 30 C atoms, each of which may be substituted by one or more non-aromatic radicals R¹, where a plurality of substituents R¹, both on the same ring and also on different rings, may together in turn form a further mono- or polycyclic, aliphatic or aromatic ring system;
R² is, identically or differently on each occurrence, H or an aliphatic or aromatic hydrocarbon radical having 1 to 20 C atoms;
n is 1, 2 or 3;
the ligands L' and L" in formula (1) here are monoanionic, bidentatechelating ligands; m and o are, identically or differently on each occurrence, 0, 1 or 2.

2. Compounds according to Claim 1, **characterised in that** Cy1 and Cy2 represent aromatic or heteroaromatic systems.

3. Compounds according to Claim 2, containing a sub-structure M(L)ₙ of the formula (2a) 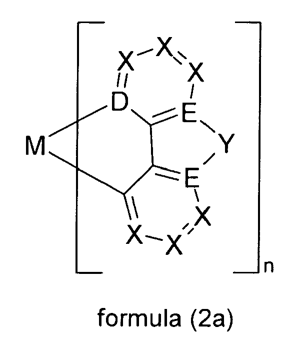 where M, Y, R, R¹, R², L', L" and n have the same meaning as described above, and the following applies to the other symbols:
D is, identically or differently on each occurrence, nitrogen or phosphorus;
X is, identically or differently on each occurrence, CR¹, N or P; or (X-X) or (X=X) (i.e. two adjacent X) stands for NR¹, S or O; or (X-X) or (X=X) (i.e. two adjacent X) stands for CR¹, N or P if the symbol E in the corresponding ring stands for N;
E is, identically or differently on each occurrence, C or N, with the proviso that if the symbol E stands for N, precisely one unit X-X (i.e. two adjacent X) in the corresponding ring is equal to CR¹, N or P.

4. Compounds of the formula (1 a) according to Claim 3,
M(L)ₙ(L')ₘ(L")ₒ formula (1a)
containing at least one sub-structure M(L)ₙ of the formula (2b) 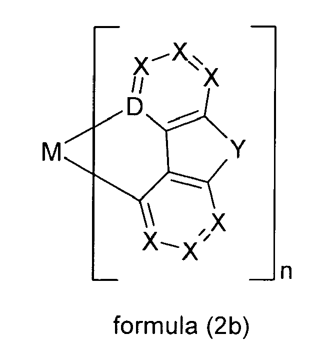 and optionally containing a sub-structure M(L')ₘ of the formula (3) 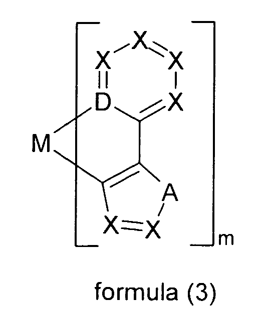 where M, D, R, R¹, R², L", n, m and o have the same meaning as described above, and furthermore:
X is, identically or differently on each occurrence, CR¹, N or P; or (X-X) or (X=X) (i.e. two adjacent X) stands for NR¹, S or O;
A is, identically or differently on each occurrence, -CR¹=CR¹-, -N=CR¹-, -P=CR¹-, -N=N-, -P=N-, NR¹, O or S;
with the proviso that each of the two rings represents a five- or six-membered ring.

5. Compounds according to one or more of Claims 1 to 4, **characterised in that** monoanionic, bidentate ligands L" are selected from the group of the 1,3-diketonates derived from 1,3-diketones, 3-ketonates derived from 3-ketoesters, carboxylates derived from aminocarboxylic acids, salicyliminates derived from salicylimines, and borates of nitrogen-containing heterocycles.

6. Compounds according to one or more of Claims 1 to 5, **characterised in that** the index n = 2 or 3.

7. Compounds according to Claim 6, **characterised in that** the indices m = o = 0.

8. Compounds according to one or more of Claims 1 to 7, **characterised in that** the symbol Y stands for CR₂, C(=O), C(=CR₂), O, S, NR, PR, P(=O)R or BR.

9. Compounds according to Claim 8, **characterised in that** the ligand which produces structures of the formula (2) or formula (2a) or formula (2b) is a spiro compound, where the symbol Y stands for CR₂ and represents the spiro atom, in particular derivatives of azaspirobifluorene.

10. Compounds according to one or more of Claims 1 to 9, **characterised in that** the symbol D = N.

11. Compounds according to one or more of Claims 1 to 10, **characterised in that** the symbol X = CR¹.

12. Use of ligands which result in sub-structures of the formula (2) according to Claim 1 or formula (2a) according to Claim 3 or formula (2b) according to Claim 4 in the complex for the preparation of the compounds of the formula (1) according to Claim 1 or formula (1a) according to Claim 4.

13. Process for the preparation of the compounds according to one or more of Claims 1 to 11 by reaction of the corresponding free ligands with metal alkoxides of the formula (4), with metal ketoketonates of the formula (5) or with mono- or polynuclear metal halides of the formula (6), (7) or (8) 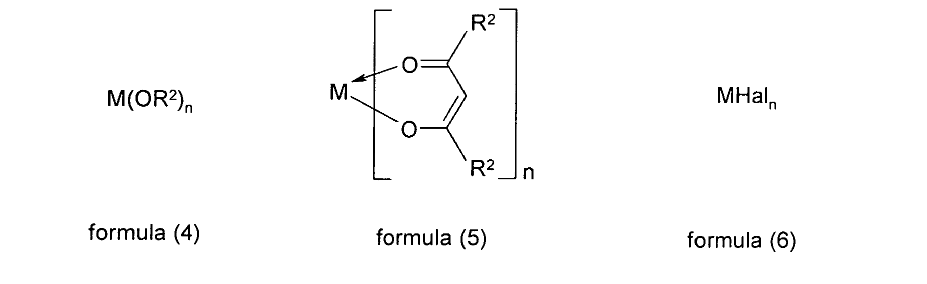 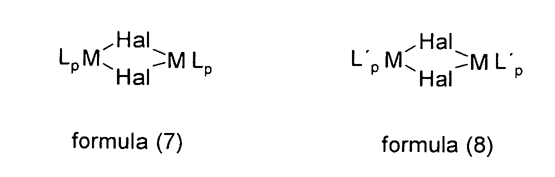 where the symbols M, n and R² have the meanings indicated in Claim 1, p = 1 for divalent metals, p = 2 for trivalent metals and Hal = F, Cl, Br or I.

14. Process according to Claim 13, **characterised in that** metal compounds which carry both alkoxide and/or halide and/or hydroxyl radicals and also ketoketonate radicals are used, and **in that** these compounds may also be charged.

15. Conjugated, partially conjugated or non-conjugated oligomers, polymers or dendrimers comprising one or more of the compounds according to one or more of Claims 1 to 11, where at least one of the radicals R and R¹ defined above, preferably R¹, represents a bond to the polymer or dendrimer.

16. Polymers according to Claim 15, **characterised in that** they are selected from the classes of the polyfluorenes, polyspirobifluorenes, polydihydrophenanthrenes, polyindenofluorenes, polyphenanthrenes, poly-para-phenylenes, polycarbazoles, polyketones, polysilanes or polythiophenes or also copolymers which contain various of these units.

17. Use of compounds, oligomers, polymers and/or dendrimers according to one or more of Claims 1 to 11 and/or 15 to 16 in organic electronic components.

18. Organic electronic components comprising one or more compounds, oligomers, polymers and/or dendrimers according to one or more of Claims 1 to 11 and/or 15 to 16.

19. Organic electronic device according to Claim 18, selected from the group of the organic and polymeric light-emitting diodes (OLEDs, PLEDs), organic field-effect transistors (O-FETs), organic thin-film transistors (O-TFTs), organic integrated circuits (O-ICs), organic solar cells (O-SCs), organic light-emitting transistors (O-LETs), organic field-quench devices (O-FQDs), light-emitting electrochemical cells (LECs) and organic laser diodes (O-lasers).

## Revendications

1. Composés de la formule (1)
M(L)ₙ(L')ₘ(L")ₒ formule (1)
contenant une sous-structure M(L)ₙ de la formule (2) 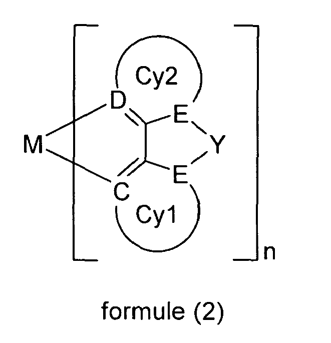 où ce qui suit s'applique aux symboles et indices utilisés :
M est, pour chaque occurrence, iridium, platine, palladium, or, tungstène, rhénium, ruthénium ou osmium ;
D est, de manière identique ou différente pour chaque occurrence, un hétéroatome sp²-hybridisé comportant une paire d'électrons de non liaison, laquelle se coordonne à M ;
C est, pour chaque occurrence, un atome de carbone sp²-hybridisé qui se lie à M ;
E est, de manière identique ou différente pour chaque occurrence, un atome de carbone ou d'azote sp²-hybridisé ;
Y est, de manière identique ou différente pour chaque occurrence, CR₂, C(=O), C(=NR), C(=N-NR₂), C(=CR₂), SiR₂, O, S, S(=O), S(=O)₂, Se, NR, PR, P(=O)R, AsR, As(=O)R ou BR ;
Cy1 est, de manière identique ou différente pour chaque occurrence, un homo- ou hétérocycle en option R¹-substitué qui se lie à M via un atome de carbone sp²-hybridisé ;
Cy2 est, de manière identique ou différente pour chaque occurrence, un hétérocycle en option R¹-substitué qui se coordonne à M via l'atome D ;
R est, de manière identique ou différente pour chaque occurrence, H, F, CN, un groupe alkyle ou alcoxy en chaîne droite comportant de 1 à 40 atomes de C ou un groupe alkyle ou alcoxy ramifié ou cyclique comportant de 3 à 40 atomes de C, où, dans chaque cas, un ou plusieurs groupes CH₂ non adjacents peut/peuvent être remplacé(s) par -R²C=CR²-, -C≡C-, Si(R²)_{2,} Ge(R²)₂, Sn(R²)₂, -O-, -S-, -NR²-, -(C=O)-, -(C=NR²)-, -P=O(R²)- ou -CONR²- et où un ou plusieurs atomes de H peut/peuvent être remplacé(s) par F, ou un système aromatique ou hétéroaromatique ou un groupe aryloxy ou hétéroaryloxy comportant de 1 à 30 atomes de C, lesquels peuvent être substitués par un ou plusieurs radicaux R¹ ; deux radicaux R ici peuvent également former un autre système de cycle aliphatique ou aromatique l'un avec l'autre ;
R¹ est, de manière identique ou différente pour chaque occurrence, H, F, CI, Br, I, OH, NO₂, CN, N(R²)_{2,} un groupe alkyle ou alcoxy en chaîne droite comportant de 1 à 40 atomes de C ou un groupe alkyle or alcoxy ramifié ou cyclique comportant de 3 à 40 atomes de C, où, dans chaque cas, un ou plusieurs groupes CH₂ non adjacents peut/peuvent être remplacé(s) par -R²C=CR²-, -C=C-, Si(R²)₂, Ge(R²)₂, Sn(R²)₂, -O-, -S-, -NR²-, -(C=O)-, -(C=NR²)-, -P=O(R²)-, -COOR²- oru-CONR²- et où un ou plusieurs atomes de H peut/peuvent être remplacé(s) par F, ou un système aromatique ou hétéroaromatique ou un groupe aryloxy ou hétéroaryloxy comportant de 1 à 30 atomes de C, dont chacun peut être substitué par un ou plusieurs radicaux R¹ non aromatiques, où une pluralité de substituants R¹, à la fois sur le même cycle et également sur des cycles différents, peuvent ensemble à leur tour former un autre système de cycles aliphatique ou aromatique, mono- ou polycyclique;
R² est, de manière identique ou différente pour chaque occurrence, H ou un radical hydrocarbone aliphatique ou aromatique comportant de 1 à 20 atomes de C ;
n est 1, 2 ou 3 ;
les ligands L' et L" dans la formule (1) ici sont des ligands monoanioniques, chélatants bidentés ; m et o sont, de manière identique ou différente pour chaque occurrence, 0, 1 ou 2.

2. Composés selon la revendication 1, **caractérisés en ce que** Cy1 et Cy2 représentent des systèmes aromatiques ou hétéroaromatiques.

3. Composés selon la revendication 2, contenant une sous-structure M(L)ₙ de la formule (2a) 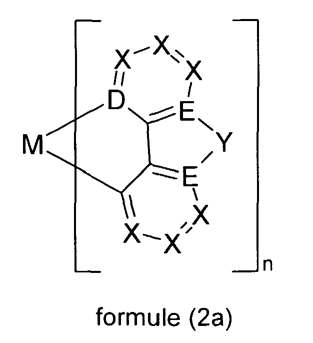 où M, Y, R, R¹, R², L', L" et n présentent la même signification que décrit ci avant, et ce qui suit s'applique aux autres symboles :
D est, de manière identique ou différente pour chaque occurrence, azote ou phosphore ;
X est, de manière identique ou différente pour chaque occurrence, CR¹, N ou P ;
ou (X-X) ou (X=X) (i.e. deux X adjacents) représente NR¹, S ou O ;
ou (X-X) ou (X=X) (i.e. deux X adjacents) représente CR¹, N ou P si le symbole E dans le cycle correspondant représente N;
E est, de manière identique ou différente pour chaque occurrence, C ou N, étant entendu que si le symbole E représente N, précisément une unité X-X (i.e. deux X adjacents) dans le cycle correspondant est égale à CR¹, N ou P.

4. Composés de la formule (1a) selon la revendication 3,
M(L)ₙ(L')ₘ(L")ₒ formule (1a)
contenant au moins une sous-structure M(L)ₙ de la formule (2b) 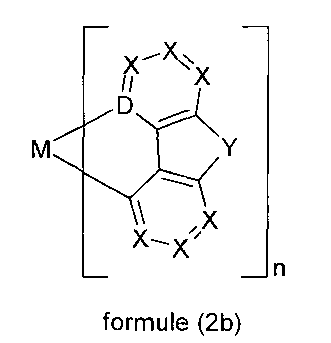 et en option contenant une sous-structure M(L')ₘ de la formule (3) 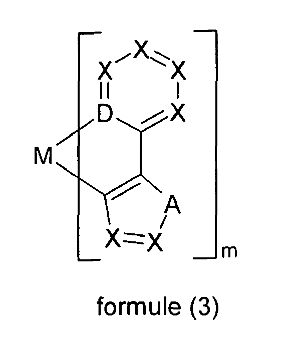 où M, D, R, R¹, R², L", n, m et o présentent la même signification que décrit ci avant, et en outre :
X est, de manière identique ou différente pour chaque occurrence, CR¹, N ou P ; ou (X-X) ou (X=X) (i.e. deux X adjacents) représente NR¹, S ou O ;
A est, de manière identique ou différente pour chaque occurrence, -CR¹=CR¹-, -N=CR¹-, -P=CR¹-, -N=N-, -P=N-, NR¹, O ou S ;
étant entendu que chacun des deux cycles représente un cycle à cinq ou six éléments.

5. Composés selon une ou plusieurs des revendications 1 à 4, **caractérisés en ce que** des ligands monoanioniques, bidentés L" sont choisis parmi le groupe 1,3-dicétonates dérivés des 1,3-dicétones, 3-cétonates dérivés des 3-cétoesters, carboxylates dérivés des acides aminocarboxyliques, salicyliminates dérivés des salicylimines, et borates d'hétérocycles contenant azote.

6. Composés selon une ou plusieurs des revendications 1 à 5, **caractérisés en ce que** l'indice n = 2 ou 3.

7. Composés selon la revendication 6, **caractérisés en ce que** les indices m = o = 0.

8. Composés selon une ou plusieurs des revendications 1 à 7, **caractérisés en ce que** le symbole Y représente CR₂, C(=O), C(=CR₂), O, S, NR, PR, P(=O)R ou BR.

9. Composés selon la revendication 8, **caractérisés en ce que** le ligand qui produit les structures de la formule (2) ou de la formule (2a) ou de la formule (2b) est un composé spiro, où le symbole Y représente CR₂ et représente l'atome spiro, en particulier des dérivés d'azaspirobifluorène.

10. Composés selon une ou plusieurs des revendications 1 à 9, **caractérisés en ce que** le symbole D = N.

11. Composés selon une ou plusieurs des revendications 1 à 10, **caractérisés en ce que** le symbole X = CR¹.

12. Utilisation de ligands qui aboutissent à des sous-structures de la formule (2) selon la revendication 1 ou de la formule (2a) selon la revendication 3 ou de la formule (2b) selon la revendication 4 dans le complexe pour la préparation des composés de la formule (1) selon la revendication 1 ou de la formule (1 a) selon la revendication 4.

13. Procédé pour la préparation des composés selon une ou plusieurs des revendications 1 à 11 par réaction des ligands libres correspondants avec des alcoxydes métalliques de la formule (4), avec des cétocétonates de la formule (5) ou avec des halogénures métalliques mono- ou polynucléaires de la formule (6), (7) ou (8) 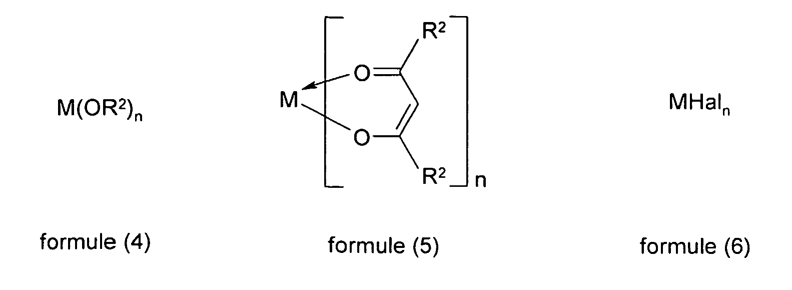 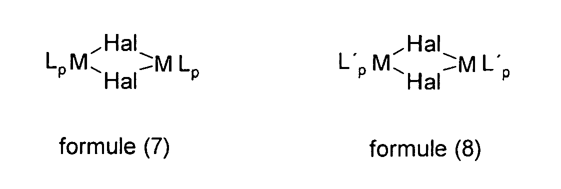 où les symboles M, n et R² présentent les significations indiquées dans la revendication 1, p = 1 pour les métaux divalents, p = 2 pour les métaux trivalents et Hal = F, CI, Br ou I.

14. Procédé selon la revendication 13, **caractérisé en ce que** des composés métalliques qui sont porteurs à la fois de radicaux alcoxyde et/ou halogénure et/ou de radicaux hydroxyle et également de radicaux cétocétonate sont utilisés, et **en ce que** ces composés peuvent également être chargés.

15. Oligomères, polymères ou dendrimères conjugués, partiellement conjugués ou non conjugués comprenant un ou plusieurs des composés selon une ou plusieurs des revendications 1 à 11, où au moins l'un des radicaux R et R¹ définis ci avant, de préférence R¹, représente une liaison sur le polymère ou dendrimère.

16. Polymères selon la revendication 15, **caractérisés en ce qu'**ils sont choisis parmi les classes polyfluorènes, polyspirobifluorènes, polydihydrophénanthrènes, polyindénofluorènes, polyphénanthrènes, polyparaphénylènes, polycarbazoles, polycétones, polysilanes ou polythiophènes ou également copolymères qui contiennent diverses de ces unités.

17. Utilisation de composés, oligomères, polymères et/ou dendrimères selon une ou plusieurs des revendications 1 à 11 et/ou 15 à 16 dans des composants électroniques organiques.

18. Composants électroniques organiques comprenant un ou plusieurs composés, oligomères, polymères et/ou dendrimères selon une ou plusieurs des revendications 1 à 11 et/ou 15 à 16.

19. Dispositif électronique organique selon la revendication 18, choisi parmi le groupe des diodes émettrices de lumière organiques et polymériques (OLED, PLED), des transistors à effet de champ organiques (O-FET), des transistors à film mince organiques (O-TFT), des circuits intégrés organiques (O-IC), des cellules solaires organiques (O-SC), des transistors émetteurs de lumière organiques (O-LET), des dispositifs à extinction de champ organiques (O-FQD), des cellules électrochimiques émettrices de lumière (LEC) et des diodes laser organiques (O-laser).
